# EUROPEAN PATENT APPLICATION

(11) **EP 4 640 765 A1**
(43) Date of publication of application: **29.10.2025**
(21) Application number: 23907165.7
(22) Date of filing: 22.12.2023
(51) Int. Cl.: C08L 83/07, C08G 77/20, C08L 83/05, C09J 11/06, C09J 183/02, C09J 183/05, C09J 183/08, H01L 23/29, H01L 23/31

(54) **CURABLE SILICONE COMPOSITION, CURED PRODUCT OF SAME, AND USE OF SAID COMPOSITION**

(30) Priority: 23.12.2022 JP 2022206371
(71) Applicant: Dow Toray Co., Ltd., Tokyo 140-8617 (JP)
(72) Inventor: YAMAZAKI, Ryosuke, Ichihara-shi Chiba 299-0108 (JP); AKIYAMA, Katsuhiro, Ichihara-shi Chiba 299-0108 (JP); IMAIZUMI, Toru, Ichihara-shi Chiba 299-0108 (JP)
(74) Representative: Elkington and Fife LLP
(86) International application number: PCT/JP2023/046057
(87) International publication number: WO 2024/135805

(57) **Abstract**

ABSTRACT: [Problem] To provide a curable silicone composition that forms a cured product that can be rapidly cured at a low temperature, has excellent storage stability, is relatively hard from curing, and has low surface tack, and the cured product thereof and the usage. [Solution] A curable silicone composition comprising: (A) an organopolysiloxane having a curing reactive functional group at a molecular terminal and the content thereof in a range of 0.001 to 10 mass%; (B) an organohydrogenpolysiloxane; (C) a hydrosilylation reaction catalyst; (D) a branched organopolysiloxane having a curing reactive functional group in an amount exceeding 10 mass% in a molecule at a molecular terminal and containing 10 mol% or more of a branched siloxane unit, wherein the content of component (D) is in the range of 0.1 to 5 mass% relative to the total amount of components (A) to (D).

## Description

### TECHNICAL FIELD

This invention is related to a curable silicone composition that forms a cured product that can be rapidly cured at a low temperature between room temperature (25°C) to 60°C or lower, has excellent storage stability, is relatively hard from curing, and has low surface tack, the cured product thereof, and the usage thereof. The present invention further relates to an application of the composition or cured product (particularly including a semiconductor device or the like having a semiconductor member, an optical semiconductor device member, or other member for a semiconductor and the cured product).

### BACKGROUND ART

Curable silicone compositions can be cured to form cured products having excellent heat resistance, cold resistance, electrical insulation, weather resistance, water repellency, and transparency, and are utilized in a wide range of industrial fields. In general, a cured product of such curable silicone compositions is less prone to discoloration compared with other organic materials and has reduced deterioration of physical properties over time, and therefore is also suitable as a sealing agent for optical materials and semiconductor devices.

The hydrosilylation reaction is often used as the reaction for curing the curable silicone composition because of its high reaction efficiency, but this reaction is a thermosetting reaction and generally requires a temperature of 100°C or higher for curing. On the other hand, Patent Document 1 and the like propose that a curing reaction is allowed to proceed at room temperature by using a photoactive hydrosilylation reaction catalyst and using irradiation with ultraviolet light or the like as a trigger, but since curing takes a long time at room temperature, a method for completely solving the technical problem of curing at a low temperature in a short time has not been found.

The present applicant has proposed, in Patent Document 2 and Patent Document 3, a silicone seat or film including hot-melt curable silicone compositions, and a silicone adhesive including a cartridge, pail, drum filled with these compositions. These silicone compositions achieve both curing at a temperature of about 100°C and storage stability of the material by using a special curing catalyst.

On the other hand, from the viewpoint of making the most of the characteristics of the hot melt, it is preferable that the curable composition can be rapidly cured at a low temperature around room temperature (25°C) at a desired timing in the process, but the compositions disclosed in Patent Documents 2 and 3 are not cured around room temperature. Therefore, a composition having curing reactivity is strongly expected, in which the curing reaction does not proceed at all by heat applied in a production process or a process of temporarily fixing the composition to an adherend before curing, but the curing reaction proceeds rapidly even at room temperature at a desired curing timing. However, as described above, it is understood that there is a trade-off relationship between the low-temperature rapid curability at around room temperature (25°C) and the storage stability of the composition on the one hand and the reaction controllability after hot melting in the related art on the other hand, and a composition capable of solving this problem has not been proposed.

### RELATED ART DOCUMENTS

### PATENT DOCUMENTS

Patent Document 1: JP 2013-87199 A
Patent Document 2: WO 2021/200643 A1
Patent Document 3: WO 2022/138336 A1

### SUMMARY OF THE INVENTION

### PROBLEM TO BE SOLVED BY THE INVENTION

Some objects of the present invention are: to provide a curable silicone composition that can be rapidly cured at a low temperature (including room temperature) of 60°C or lower, has excellent storage stability and reaction control, and thus can be in the form of a one-component composition; to further provide various methods of imparting hot-melt properties to the composition; and to provide a relatively hard cured product with little surface tack obtained by curing the composition. Furthermore, by imparting hot melt properties to the curable silicone composition of the present invention and passing through various processing processes, it is possible to provide a sheet or film, and a composition for hot dispensing filled in a cartridge, pail, drum, or the like. Furthermore, yet another object of the present invention is to provide: a member for a semiconductor device including a cured product of the curable silicone composition; a semiconductor device having the cured product; and a method of molding a cured product.

### MEANS FOR SOLVING THE PROBLEM

As a result of intensive studies, the present inventors have found that, by using a certain amount of a branched organopolysiloxane having a curing reactive functional group containing a carbon-carbon double bond in an amount exceeding 10 mass% in a molecule at a molecular terminal and containing 10 mol% or more of a branched siloxane unit represented by RSiO_{3/2} (where R is a monovalent organic group, a hydroxyl group, or an alkoxy group) or SiO_{4/2}, in a curable silicone composition containing a specific main agent, crosslinking agent, and hydrosilylation reaction catalyst, rapid curing of the composition at a low temperature of room temperature (25°C) to 60°C or lower can be achieved by activating the hydrosilylation reaction catalyst by heating and irradiation with a high energy beam, and thus the present invention has been attained. The composition may be in a form of a liquid composition including a one-component composition, or in a form of a solid or semi-solid composition having hot melt properties, and may be molded into a sheet shape or the like.

More specifically, the problem can be solved by a curable silicone composition comprising:
(A) an organopolysiloxane having a curing reactive functional group containing a carbon-carbon double bond at a molecular terminal and having a content thereof in a range of 0.001 to 10 mass%;
(B) an organohydrogenpolysiloxane having at least 2 silicon-bonded hydrogen atoms in each molecule at a molecular terminal;
(C) a hydrosilylation reaction catalyst;
(D) a branched organopolysiloxane having a curing reactive functional group containing a carbon-carbon double bond in an amount exceeding 10 mass% in a molecule at a molecular terminal and containing 10 mol% or more of a branched siloxane unit represented by RSiO_{3/2} (where R is a monovalent organic group, a hydroxyl group, or an alkoxy group) or SiO_{4/2},
wherein the content of the component (D) is in the range of 0.1 to 5 mass% relative to the total amount of components (A) to (D). Here, component (C) may be at least one kind of hydrosilation catalysts selected from (C1) a hydrosilation reaction catalyst which exhibits activity in the composition when heated and (C2) a hydrosilation reaction catalyst which exhibits activity in the composition when irradiated with a high energy beam. The composition may also be liquid, in particular in a form of a one-component composition.

Similarly, the composition as a whole may have hot melt properties, and contain the above components, and the following components based on the amount of the resin component (hereinafter, sometimes expressed as "component (R)"):
(R) 100 parts by mass of an organopolysiloxane resin component that is solid at 25°C, containing the following component (A1) and component (E) at a mass ratio of 20:80 to 90:10:
(A1) a branched organopolysiloxane having a curable reactive functional group containing a carbon-carbon double bond at a molecular terminal and containing 20 mol% or more of a branched siloxane unit represented by RSiO_{3/2} (wherein R is a monovalent organic group, a hydroxyl group, or an alkoxy group) or SiO_{4/2};
(E) a branched organopolysiloxane that does not have a curing reactive functional group containing a carbon-carbon double bond in a molecule, and that contains 20 mol% or more of a branched siloxane unit as represented by SiO_{4/2};
(A2-1) 10 to 100 parts by mass of a linear organopolysiloxane having a curing reactive functional group containing a carbon-carbon double bond at both ends of the molecular chain;
wherein a combination of two types of organopolysiloxane serves as component (B), namely,
(B-1) a linear organopolysiloxane represented by the general formula:

   HR⁴₂SiO(R⁴₂SiO)ₙSiR⁴₂H,

   and
(B-2) a branched organopolysiloxane expressed by the average unit formula:

   (R⁴SiO_{3/2})ₚ(R⁴₂SiO_{2/2})_{q}(HR⁴₂SiO_{1/2})ᵣ(SiO_{4/2})ₛ(XO_{1/2})ₜ.
(wherein R⁴ are the same or different phenyl groups or alkyl groups having 1 to 6 carbon atoms, provided that the phenyl group content is within the range of 30 to 70 mol% for all R⁴,
n is an integer within the range of 1 to 50, p is a positive number, q is 0 or a positive number, r is a positive number, s is 0 or a positive number, t is 0 or a positive number, q/p is a number within the range of 0 to 10, r/p is a number within the range of 0.1 to 5, s/(p + q + r + s) is a number within the range of 0 to 0.3, and t/(p + q + r + s) is a number within the range of 0 to 0.4.)
and the amounts of component (B-1) and component (B-2) are in a range of (B-1): (B-2) = 0.05 to 0.6:0.4 to 0.95 per one curing reactive functional group containing a carbon-carbon double bond in the entire composition;
wherein component (C) is at least one kind of hydrosilation catalyst (catalyst amount) selected from the following:
   (C1) a hydrosilylation catalyst which exhibits activity in the composition when heated;
   (C2) a hydrosilation reaction catalyst which exhibits activity in the composition when irradiated with a high energy beam
      and
   (D) a branched organopolysiloxane having a curing reactive functional group containing a carbon-carbon double bond in an amount exceeding 10 mass% at a molecular terminal and containing 10 mol% or more of a branched siloxane unit represented by RSiO_{3/2} (where R is a monovalent organic group, a hydroxyl group, or an alkoxy group) or SiO_{4/2} in a molecule;
   wherein the content of component (D) is in the range of 0.1 to 5 mass% relative to the total amount of the components (A) to (D), and thus the present inventors have found that the above problems can be solved by the above composition, and have completed the present invention.

Furthermore, the present inventors have found that the above problems can be solved by a cured product obtained by curing the above composition and the use thereof, and have completed the present invention. Similarly, the present inventors have found that the above problems can be solved by a low-temperature curing method for the curable silicone composition wherein the composition is cured through a process of activating one or more catalysts for a hydrosilylation reaction selected from the following processes, within a temperature in the range of 25°C to 60°C:
process A: a process of activating a hydrosilylation reaction catalyst by heating the composition at a temperature of higher than 25°C and 60°C or lower; and process B: a process of activating a hydrosilylation reaction catalyst by irradiating the composition with a high energy beam.

### EFFECT OF THE INVENTION

The curable silicone composition of the present invention has excellent storage stability particularly in the form of a one-component composition or a hot-melt composition, unless a process of activating the hydrosilylation reaction catalyst is performed, and once the catalyst is activated, rapid curing is possible even at a low temperature of 60°C or less (including room temperature (25°C)), and a relatively hard cured product with little surface tack can be obtained. In particular, since the curable silicone composition of the present invention can impart hot-melt properties to the composition as a whole, a method of use can be provided that makes the most of both the characteristics of the hot-melt composition, namely, the rapid curing characteristics at low temperatures and the absence of shape change at room temperature.

In addition, the curable silicone composition of the present invention can be in a form of a one-component composition, or in a form of a sheet or film through various processing processes, and further, it is possible to provide a curable silicone composition for hot dispensing filled in a cartridge, pail, drum, or the like. Similarly, a member for a semiconductor device that makes up a cured product of the curable silicone composition of this invention, a semiconductor device having the cured product, etc. can be provided. Furthermore, the present invention can provide a low-temperature curing method in a temperature range of 25°C to 60°C, using the above curable silicone composition.

### BRIEF DESCRIPTION OF THE DRAWINGS

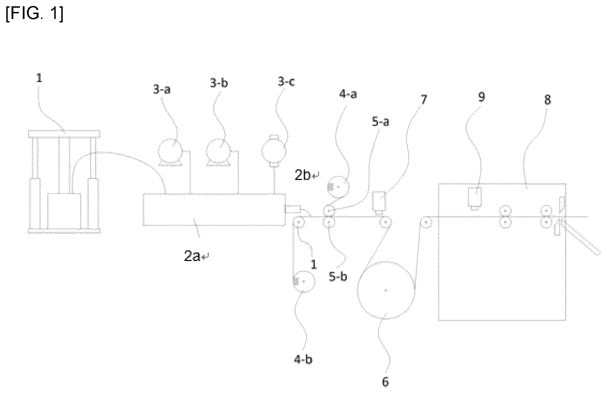

FIG. 1 is a diagram depicting the overall configuration of the manufacturing device (all parts, including sheet forming) of the hot-melt curable silicone composition used in the examples.

### DESCRIPTION OF THE PREFERRED EMBODIMENTS

Embodiments of the present invention will be described below in detail. The present invention is not limited by the following embodiments, and various types of modifications may be made within the scope of the gist of the present invention.

In the present specification, room temperature means the temperature of an environment where the curable silicone composition of the present invention is handled. The room temperature generally refers to 15°C to 30°C, particularly 18°C to 25°C, and particularly, in a case where "room temperature (25°C)" is described, it means "25°C".

In the present invention, unless otherwise stated, "having hot-melt properties" means the softening point of a composition is between 50 and 200°C, and the composition has a melt viscosity at 150°C (preferably, melt viscosity of less than 1000 Pa·s) and has fluid properties. Moreover, in the present specification, the curable silicone composition having hot-melt properties of the present invention is also referred to as a curable hot-melt silicone composition.

On the other hand, the curable silicone composition of the present invention may be in a form of a liquid composition, and the term "liquid" means that the composition has a fluid property at room temperature (25°C).

### [Curable Silicone Composition]

The curable silicone composition of the present invention includes at least the following components (A) to (D):
(A) an organopolysiloxane having a curing reactive functional group containing a carbon-carbon double bond at a molecular terminal and having a content thereof in a range of 0.001 to 10 mass%;
(B) an organohydrogenpolysiloxane having at least 2 silicon-bonded hydrogen atoms in each molecule at a molecular terminal;
(C) a hydrosilylation reaction catalyst;
(D) a branched organopolysiloxane having a curing reactive functional group containing a carbon-carbon double bond in an amount exceeding 10 mass% in a molecule at a molecular terminal and containing 10 mol% or more of a branched siloxane unit represented by RSiO_{3/2} (where R is a monovalent organic group, a hydroxyl group, or an alkoxy group) or SiO_{4/2},
wherein the content of component (D) is in the range of 0.1 to 5 mass% relative to the total amount of components (A) to (D).

However, from the viewpoint of the technical effects of the present invention, the content of component (D) needs to be in the range of 0.1 to 5 mass% relative to the total of components (A) to (D). The curable silicone composition may be in any form, including liquid, plastic, or solid, at room temperature as long as it contains the components described above, may be in a form of a one-component composition (that is, liquid at room temperature), or may be in a form having hot-melt properties as a whole (that is, non-fluid solid/semi-solid at room temperature).

### [Curable Silicone Composition with Hot-Melt Properties]

When the composition as a whole has hot-melt properties, the composition contains the above components, and the following components based on the amount of the resin component (hereinafter, sometimes expressed as "component (R)"):
(R) 100 parts by mass of an organopolysiloxane resin component that is solid at 25°C, containing the following component (A1) and component (E) at a mass ratio of 20:80 to 90:10:
(A1) a branched organopolysiloxane having a curable reactive functional group containing a carbon-carbon double bond at a molecular terminal and containing 20 mol% or more of a branched siloxane unit represented by RSiO_{3/2} (wherein R is a monovalent organic group, a hydroxyl group, or an alkoxy group) or SiO_{4/2};
(E) a branched organopolysiloxane that does not have a curing reactive functional group containing a carbon-carbon double bond in a molecule, and that contains 20 mol% or more of a branched siloxane unit as represented by SiO_{4/2};
(A2-1) 10 to 100 parts by mass of a linear organopolysiloxane having a curing reactive functional group containing a carbon-carbon double bond at both ends of the molecular chain;
wherein a combination of two types of organopolysiloxane serves as component (B), namely,
(B-1) a linear organopolysiloxane represented by the general formula:

   HR⁴₂SiO(R⁴₂SiO)ₙSiR⁴₂H,

   and
(B-2) a branched organopolysiloxane expressed by the average unit formula:

   (R⁴SiO_{3/2})ₚ( R⁴₂SiO_{2/2})_{q}(HR⁴₂SiO_{1/2})ᵣ(SiO_{4/2})ₛ(XO_{1/2})ₜ.
(wherein R⁴ are the same or different phenyl groups or alkyl groups having 1 to 6 carbon atoms, provided the phenyl group content is within the range of 30 to 70 mol% for all R⁴,
n is an integer within the range of 1 to 50, p is a positive number, q is 0 or a positive number, r is a positive number, s is 0 or a positive number, t is 0 or a positive number, q/p is a number within the range of 0 to 10, r/p is a number within the range of 0.1 to 5, s/(p + q + r + s) is a number within the range of 0 to 0.3, and t/(p + q + r + s) is a number within the range of 0 to 0.4.)
and the amounts of component (B-1) and component (B-2) are in a range of (B-1): (B-2) = 0.05 to 0.6:0.4 to 0.95 per one curing reactive functional group containing a carbon-carbon double bond in the entire composition;
wherein component (C) is at least one kind of hydrosilation catalyst (catalyst amount) selected from the following:
   (C1) a hydrosilylation catalyst which exhibits activity in the composition when heated;
   (C2) a hydrosilation reaction catalyst which exhibits activity in the composition when irradiated with a high energy beam,
      and
   (D) a branched organopolysiloxane having a curing reactive functional group containing a carbon-carbon double bond in an amount exceeding 10 mass% at a molecular terminal and containing 10 mol% or more of a branched siloxane unit represented by RSiO_{3/2} (where R is a monovalent organic group, a hydroxyl group, or an alkoxy group) or SiO_{4/2}) in a molecule;
   wherein the content of the component (D) is in the range of 0.1 to 5 mass% relative to the total amount of components (A) to (D).

Moreover, in either form of the liquid/hot-melt composition, optional components other than the above components may be contained to the extent that the object and the technical effects of the present invention are not impaired.
Each of the components will be described below in detail.

### Component (A):

Component (A) is a main agent of the present composition, and is an organopolysiloxane having a curing reactive functional group containing a carbon-carbon double bond at a molecular terminal and having a content thereof in a range of 0.001 to 10 mass%. Moreover, component (A) is clearly distinguished from component (D) described below by the content of the curing reactive functional group containing a carbon-carbon double bond of component (A).

Component (A) has a curing reactive functional group containing a carbon-carbon double bond at its molecular terminal (which is a terminal of its molecular structure if it is resinous or branched, and means both terminals of a chain molecule if it is linear). Component (A) may optionally have a curing reactive functional group containing a carbon-carbon double bond in a position other than the molecular terminal, for example, in a side chain or inside the resinous structure, but from the viewpoint of the technical effects of the present invention, it is particularly preferable that all the curing reactive functional groups containing carbon-carbon double bonds are present only at the molecular terminal.

Examples of the curing reactive functional groups containing a carbon-carbon double bond in component (A) include vinyl groups, allyl groups, butenyl groups, pentenyl groups, hexenyl groups, heptenyl groups, octenyl groups, and other alkenyl groups having 2 to 12 carbon atoms. However, vinyl groups, allyl groups, and hexenyl groups are preferred. Examples of groups bonded to the silicon atom other than alkenyl groups in component (A) include alkyl groups having 1 to 12 carbon atoms such as methyl groups, ethyl groups, propyl groups, butyl groups, pentyl groups, hexyl groups, heptyl groups, and the like; aryl groups having 6 to 12 carbon atoms such as phenyl groups, tolyl groups, xylyl groups, and the like; and aralkyl groups having 7 to 12 carbon atoms, such as benzyl groups, phenethyl groups, and the like, but methyl groups are preferable. Furthermore, component (A) may have small amounts of hydroxyl groups or alkoxy groups having 1 to 3 carbon atoms, such as methoxy groups and ethoxy groups, bonded to silicon atoms, so long as the object of the present invention is not impaired.

There are no limitations on the molecular structure of component (A), and examples include linear, partially branched straight-chain, branched-chain, and resinous. Examples of this component (A) include linear organopolysiloxane such as dimethylpolysiloxanes capped at both molecular terminals with dimethylvinylsiloxy groups, copolymers of dimethylsiloxane and methylvinylsiloxane capped at both molecular terminals with dimethylvinylsiloxy groups; branched organopolysiloxane such as copolymers containing a siloxane unit represented by the formula: (CH₂=CH)(CH₃)₂SiO_{1/2} and a siloxane unit represented by the formula: SiO_{4/2}, copolymers containing a siloxane unit represented by the formula: (CH₂=CH)(CH₃)₂SiO_{1/2} and a siloxane unit represented by the formula: CH₃SiO_{3/2}, copolymers containing a siloxane unit represented by the formula: (CH₂=CH)(CH₃)₂SiO_{1/2} and a siloxane unit represented by the formula: C₆H₅SiO_{3/2}, copolymers containing a siloxane unit represented by the formula: (CH₃)₃SiO_{1/2}, a siloxane unit represented by the formula: (CH₂=CH)(CH₃)₂SiO_{1/2}, and a siloxane unit represented by the formula: SiO_{4/2}, copolymers containing a siloxane unit represented by the formula: (CH₃)₃SiO_{1/2}, a siloxane unit represented by the formula: (CH₂=CH)(CH₃)₂SiO_{1/2}, and a siloxane unit represented by the formula: CH₃SiO_{3/2}, and copolymers containing a siloxane unit represented by the formula: (CH₃)₃SiO_{1/2}, a siloxane unit represented by the formula: (CH₂=CH)(CH₃)₂SiO_{1/2}, and a siloxane unit represented by the formula: C₆H₅SiO_{3/2}.

Component (A) may have any of the above-described structures, or may be a mixture of a plurality of components, but the curing reactive functional group having a carbon-carbon double bond needs to be present at a molecular terminal, and the content thereof in one molecule needs to be within the range of 0.001 to 10 mass%. This is because the presence of the functional group at the molecular chain terminal increases the curing rate, and enables a rapid low-temperature curing reaction. This is also because when the content of the curing reactive functional group having a carbon-carbon double bond is in the range of 0.001 to 10 mass% per molecule, the mechanical strength of the cured product obtained by the curing reaction becomes excellent.

### [Combined Use of Components (A1), (A2), and (E)]

Here, at least a portion of component (A) is preferably (A1) a branched organopolysiloxane having a curable reactive functional group containing a carbon-carbon double bond at a molecular terminal and containing 20 mol% or more of a branched siloxane unit represented by RSiO_{3/2} (wherein R is a monovalent organic group, a hydroxyl group, or an alkoxy group) or SiO_{4/2}.

Moreover, component (A) is preferably a mixture of component (A1) and component (A2), a linear or branched organopolysiloxane that is liquid or has plasticity at 25°C (room temperature), having a curing reactive functional group including a carbon-carbon double bond at a molecular terminal.

### [Design Guideline of Hot-Melt Composition]

Here, by using components (A1) and (A2) described above in combination as component (A), and by using component (A) in combination with a certain amount of component (E) described below, i.e., a branched organopolysiloxane that does not have a curing reactive functional group containing carbon-carbon double bonds in the molecule and contains 20 mol% or more of a branched siloxane unit represented by SiO_{4/2} (that is, a branched organopolysiloxane that does not have curing reactive properties), it is possible to impart hot-melt properties to the curable silicone composition as a whole according to the present invention. That is, by including components (A1) and (E) described above at a mass ratio of 20:80 to 90:10 as the organopolysiloxane resin component (component R) that is solid at 25°C, and further using 10 to 100 parts by mass of (A2) a linear or branched organopolysiloxane that is liquid or has plasticity (in other words, a reactive organopolysiloxane that has fluidity at room temperatures) in combination, it is possible to design a composition that has hot-melt properties for the curable silicone composition as a whole according to the present invention. Here, regarding the usage amount of component (A2), the range of 10 to 70 parts by mass is preferable, and the range of 15 to 50 parts by mass is more preferable. If the amount of component (A2) is within the aforementioned range, the resulting curable silicone composition exhibits favorable hot-melt properties, the mechanical strength of a cured product obtained by curing the curable silicone composition can be increased, and the stickiness of the resulting cured silicone composition at room temperature can be reduced, thereby improving the handling workability of the composition.

Moreover, preferably, as component (A2), a linear organopolysiloxane having a curing reactive functional group containing a carbon-carbon double bond at both ends of the molecular chain (A2-1) is particularly preferable.

### [Design Guideline of Liquid Composition]

In contrast, by reducing the usage amount of the organopolysiloxane resin component that is solid at 25°C such as component (A1) and the like (= component (R)) and increasing the usage amount of component (A2) (preferably component (A2-1) described above), it is possible to design a composition that is liquid or fluid at room temperature for the curable silicone composition as a whole according to the present invention. The liquid curable silicone composition of the present invention is particularly useful as a one-component composition from the viewpoint of its storage stability and low-temperature rapid curing properties.

### [Component (A1)]

More specifically, as component (A1), it is possible to use an organopolysiloxane resin that is preferably solid at 25°C, and has a curable reactive functional group containing a carbon-carbon double bond at the molecular terminal and contains 20 mol% or more of a branched siloxane unit represented by RSiO_{3/2} (where R is a monovalent organic group, a hydroxyl group, or an alkoxy group) or SiO_{4/2}. Moreover, component (A1) may further contain a siloxane unit represented by R₃SiO_{1/2}, R₂SiO_{2/2}, or a hydroxyl group, or an alkoxy group represented by R²O_{1/2} (R² represents a hydrogen atom or an alkyl group having 1 to 10 carbon atoms), but preferably includes siloxane units represented by SiO_{4/2} making up at least 20 mol% or more, preferably 40 mol% or more, and particularly preferably within a range of 40 to 90 mol% of all siloxane units. In addition, since component (A1) is one of components (A), the concentration of the functional group containing a carbon-carbon double bond needs to be within a range of 0.001 to 10 mass%. This is because if the functional group concentration is less than the above range, the crosslinking density is too low and it is difficult to obtain a cured product having sufficient hardness, and if the functional group concentration is more than the above range, the strength of the obtained cured product tends to decrease.

Preferably, component (A1) is an organopolysiloxane resin that is solid in a solvent-free state, and preferably does not exhibit heat melting behavior at 200°C or less by itself. In order to exhibit such properties, component (A1) has a functional group in the organopolysiloxane resin that is a functional group selected from monovalent hydrocarbon groups with 1 to 10 carbon atoms, and particularly methyl groups and other alkyl groups with 1 to 10 carbon atoms, and does not substantially contain a phenyl group or other aryl group. For example, the ratio of aryl groups in all organic groups bonded to silicon atoms is preferably 5 mol% or less, and more preferably 2 mol% or less. It is particularly preferable that no aryl groups are included at all. When component (A1) contains a large amount of aryl groups such as phenyl groups, an effect of reinforcing the cured product inherent to a branched siloxane unit such as SiO_{4/2} groups may be reduced

Preferably, the functional group bonded to the silicon atom in component (A1) is a group selected from methyl groups, vinyl groups and other alkenyl groups. 70 to 99 mol% of all silicon-bonded organic groups are preferably methyl groups, 80 to 99 mol% are more preferably methyl groups, and 88 to 99 mol% are particularly preferably methyl groups, with any other organic groups bonded to a silicon atom being a vinyl group or other alkenyl group. In such a range, component (A1) is not hot-meltable alone, but is useful as a component that is particularly excellent in coloring resistance and the like at the high temperatures of a cured product obtained from the curable silicone composition of the present invention. Note that the organopolysiloxane resin of component (A1) may contain a small amount of a hydroxyl group or alkoxy group.

More suitably, component (A1) is an organopolysiloxane resin that independently does not have hot-melt properties and that is solid at 25°C, represented by
(A1-1) the following average unit formula:
   (R¹₃SiO_{1/2})ₐ(R¹2SiO_{2/2})_{b}(R¹SiO_{3/2})c(SiO_{4/2})_{d}(R²O_{1/2})ₑ
(where each R¹ independently represents a monovalent hydrocarbon group with 1 to 10 carbon atoms, but 1 to 12 mol% of all R¹s in a molecule represents an alkenyl group; each R² represents a hydrogen atom or an alkyl group with 1 to 10 carbon atoms; and a, b, c, d, and e represent numbers that satisfy 0.10 ≤ a ≤ 0.60, 0 ≤ b ≤ 0.70, 0 ≤ c ≤ 0.80, 0 ≤ d ≤ 0.65, and 0 ≤ e ≤ 0.05, but c + d > 0.20 and a + b + c + d = 1).

In the average unit formula above, each R¹ is an independent monovalent hydrocarbon group having 1 to 10 carbon atoms, and examples include methyl, ethyl, propyl, butyl, pentyl, hexyl, heptyl, and similar alkyl groups, but a methyl group is particularly preferable; vinyl, allyl, butenyl, pentenyl, hexenyl, or similar alkenyl groups, but a vinyl group and/or a 1-hexenyl group is particularly preferable; phenyl, tolyl, xylyl, or similar aryl groups, but a phenyl group is particularly preferable; and benzyl, phenethyl, and similar aralkyl groups. Furthermore, 1 to 12 mol% of all R¹s in one molecule is an alkenyl group, preferably 2 to 10 mol% of all R¹s in one molecule is an alkenyl group, and particularly preferably a vinyl group. If the alkenyl group content is less than the lower limit of the range described above, the mechanical strength (hardness and the like) of the resulting cured material may be insufficient. On the other hand, if the amount of the alkenyl group is at or below the upper limit of the range described above, the composition containing the component can achieve favorable hot-melt performance as an entire composition. Note that each R¹ preferably represents a functional group selected from methyl groups and other alkyl groups having 1 to 10 carbon atoms, and vinyl groups, hexenyl groups and other alkenyl groups, and from the perspective of a technical effect of the present invention, the R¹ preferably does not substantially contain a phenyl group or other aryl group. When a large amount of aryl groups such as phenyl groups are contained, there is a concern that toughness cannot be imparted to the obtained cured product.

In the formula above, R² is an alkyl group having a hydrogen atom or 1 to 10 carbon atoms. Examples of the alkyl group of R² include methyl, ethyl, propyl, butyl, pentyl and hexyl. The group R²O_{1/2} containing the R² corresponds to a hydroxyl group or alkoxy group of the organopolysiloxane resin of component (A).

In the formula, "a" is a number indicating the percentage of siloxane units in the general formula: R¹₃SiO_{1/2}. "a" satisfies 0.1 ≤ a ≤ 0.60, and preferably satisfies 0.15 ≤ a ≤ 0.55. If "a" is at or above the lower limit of the aforementioned range, the composition containing the component can achieve favorable hot-melt performance as a whole composition. On the other hand, if "a" is less than or equal to the upper limit of the aforementioned range, the mechanical strength (hardness, elongation rate, and the like) of the cured product obtained by curing the curable silicone composition of the present invention is not too low.

In the formula, "b" is a number indicating the percentage of siloxane units in the general formula: R¹₂SiO_{2/2}. "b" is a value that satisfies 0 ≤ b ≤ 0.70, and preferably satisfies 0 ≤ b ≤ 0.60. If "b" is less than or equal to the upper limit of the aforementioned range, the composition containing the component can achieve favorable rapid curing performance and hot-melt performance as a whole composition and a composition with little stickiness at room temperature can be obtained.

In the formula, "c" is a number indicating the percentage of siloxane units in the general formula: R³SiO_{3/2}. "c" is a value that satisfies 0 ≤ c ≤ 0.80, and preferably satisfies 0 ≤ c ≤ 0.75. If "c" is less than or equal to the upper limit of the aforementioned range, the composition containing the component can achieve favorable rapid curing performance and hot-melt performance as a whole composition and a low-tack or tack-free composition with little stickiness at room temperature can be obtained. In the present invention, "c" may be 0 and is preferably 0.

In the formula above, "d" is a number indicating the ratio of siloxane units of formula SiO_{4/2}, and must satisfy 0.00≤d≤0.65, preferably satisfies 0.20≤d≤0.65, and particularly preferably satisfies 0.25≤d≤0.65. If "d" is within the aforementioned numerical value range, the composition containing this component can achieve favorable rapid curing performance and hot-melt performance as a whole composition, and a cured product obtained by curing the composition can be relatively hard and have sufficient flexibility for practical use.

In the present invention, "c" or "d" in the aforementioned formula may be 0, but must satisfy c + d > 0.20. If the value of c + d is 0.20 or less, favorable rapid curing performance and hot-melt performance cannot be achieved for the composition as a whole, and a technical effect of the present invention may not be sufficiently achieved.

In the formula above, "e" is a number indicating the percentage of units in the general formula: R²O_{1/2}, where the units are a hydroxyl group or alkoxy group bonded to a silicon atom that can be included in the organopolysiloxane resin. "e" satisfies the equation 0 ≤ e ≤ 0.05, and preferably satisfies 0 ≤ e ≤ 0.03. If "e" is below the upper limit of the range, a material that achieves favorable rapid curing performance and hot-melt performance as an entire composition can be obtained. Note that in the formula above, the sum of "a", "b", "c" and "d", which is the sum of each siloxane unit, is equal to 1.

Component (A1) is an organopolysiloxane resin having the aforementioned properties, and is a solid at room temperature, so in order to physically blend with components (A2) and (B) and the like described below, component (A1) may be used in a state dissolved in a solvent or solvent mixture preferably selected from the group consisting of: toluene, xylene, mesitylene, and other aromatic hydrocarbons; tetrahydrofuran, dipropyl ether, and other ethers; hexamethyldisiloxane, octamethyltrisiloxane, decamethyltetrasiloxane, and other silicones; ethyl acetate, butyl acetate, propylene glycol monomethyl ether acetate, and other esters; acetone, methyl ethyl ketone, methyl isobutyl ketone, and other ketones; and the like. The solvent used herein can be efficiently removed in a process described later.

### [Component (A2)]

Component (A2) is a straight or branched chain organopolysiloxane, that is liquid or has plasticity at 25°C, having a curing reactive functional group containing two carbon-carbon double bonds at the molecular chain terminal. Such a curing reactive chain organopolysiloxane, when mixed with the solid organopolysiloxane resin such as component (A1) described above and component (E) described below, can exhibit hot-melt properties as an entire composition, and can be in a liquid or fluid form as the composition as a whole depending on the usage amount.

Component (A2) must have a curing reactive functional group containing a carbon-carbon double bond in a molecule. Such a curing reactive functional group is hydrosilylation reactive, and forms a cured material by a crosslinking reaction with another component. The curable reactive functional group is particularly preferably an alkenyl group similar to those of component (A1), preferably an alkenyl group having 2 to 10 carbon atoms, and examples of alkenyl groups include vinyl, allyl, butenyl, pentenyl, hexenyl, and heptenyl, with vinyl groups or hexenyl groups being particularly preferable.

Suitably, component (A2) is a linear organopolysiloxane having a curing reactive functional group containing a carbon-carbon double bond at both ends of the molecular chain (A2-1); more specifically, represented by the following structural formula:

R⁴₃SiO(SiR⁴₂O)ₖSiR⁴₃

(where each R⁴ independently represents a monovalent hydrocarbon group with 1 to 10 carbon atoms, but at least two of the R⁴s in one molecule represent alkenyl groups, and k represents a number from 20 to 5,000).
A straight-chain diorganopolysiloxane having an alkenyl group, and particularly preferably a vinyl group at both ends of a molecular chain is preferred.

In the formula, each R⁴ is an independent monovalent hydrocarbon group having 1 to 10 carbon atoms, and examples include methyl, ethyl, propyl, butyl, pentyl, hexyl, heptyl, and similar alkyl groups, but a methyl group is particularly preferable; vinyl, allyl, butenyl, pentenyl, hexenyl, or similar alkenyl groups, but a vinyl group and/or a 1-hexenyl group is particularly preferable; phenyl, tolyl, xylyl, or similar aryl groups, but a phenyl group is particularly preferable; and benzyl, phenethyl, and similar aralkyl groups. Furthermore, at least two of the R⁴ in one molecule are alkenyl groups, and preferably a vinyl group. Furthermore, each R⁴ is preferably a functional group selected from a group consisting of methyl groups and other alkyl groups having 1 to 10 carbon atoms and vinyl groups, hexenyl group and other alkenyl groups, and it is preferable that of all R⁴ s, at least two are alkenyl groups per molecule, and the remaining R⁴ are methyl groups. Note that from the viewpoint of a technical effect of the invention, R⁴ is preferably substantially free of an aryl group such as a phenyl group or the like. If a large amount of phenyl groups or other aryl groups are included, the coloring resistance at high temperatures of the cured material obtained from the curable silicone composition may deteriorate. Particularly preferably, a vinyl group or other alkenyl group is preferred at both ends of a molecular chain, with the rest of R⁴ being a methyl group.

In the formula above, k represents a number between 20 and 5,000, preferably between 30 and 3,000, and particularly preferably between 45 and 800. If k is at or above the lower limit of the aforementioned range, a curable silicone composition having little stickiness at room temperature can be obtained. On the other hand, if k is at or below the upper limit of the aforementioned range, by using component (R) in combination, the curable silicone composition can achieve a favorable hot-melt performance, and if it is liquid, a favorable handling performance, as the composition as a whole.

In addition, since component (A2) is one of components (A), the content of the functional group containing a carbon-carbon double bond needs to be in the range of 0.001 to 10 mass%. This is because if the functional group concentration is less than the above range, the crosslinking density is too low and it is difficult to obtain a cured product having sufficient hardness, and if the functional group concentration is more than the above range, the strength of the obtained cured product tends to decrease.

Here, in order to make the composition as a whole exhibit hot melt properties, it is necessary to include the components (A1) and (E) at a mass ratio of 20:80 to 90:10 as organopolysiloxane resin components (components (R)) that are solid at 25°C, and further to use 10 to 100 parts by mass of (A2) a linear or branched organopolysiloxane that is liquid or has plasticity (in other words, a reactive organopolysiloxane that has fluidity at room temperatures) in combination.

### [Component (B)]

Component (B) is a hydrosilylation crosslinking component that can react with the functional group containing a carbon-carbon double bond contained in component (A) described above, and is specifically an organohydrogenpolysiloxane. The structure thereof is not particularly limited and can be linear, branched, cyclic or resinous. However, from the perspective of excellent curing properties of the resulting composition, an organohydrogenpolysiloxane has a hydrogen diorganosiloxy unit represented by HR₂SiO_{1/2} (M^{H} unit, where R independently represents a monovalent organic group) at an end.

Two or more silicon atom-bonded hydrogen atoms in component (B) are present in one molecule, which provides sufficient cross-linking reactivity for curing and favorable hardness of the resulting cured product. Examples of the silicon atom-bonded organic groups in component (B) include monovalent hydrocarbon groups having no unsaturated aliphatic bonds, such as: methyl groups, ethyl groups, propyl groups, butyl groups, pentyl groups, hexyl groups, heptyl groups, cyclopentyl groups, cyclohexyl groups, cycloheptyl groups, and other alkyl groups; phenyl groups, tolyl groups, xylyl groups, and other aryl groups; benzyl groups, phenethyl groups, and other aralkyl groups; and the like. Of these, phenyl groups and alkyl groups having 1 to 6 carbon atoms are preferred.

There are two types of organopolysiloxane serving as component (B), namely,
(B1) a linear organopolysiloxane expressed by the general formula:

   HR⁴₂SiO(R⁴₂SiO)ₙSiR⁴₂H,

   and
(B2) a branched organopolysiloxane expressed by the average unit formula:

   (R⁴SiO_{3/2})ₚ( R⁴₂SiO_{2/2})_{q}(HR⁴₂SiO_{1/2})ᵣ(SiO_{4/2})ₛ(XO_{1/2})ₜ.
A combination of these two components (B) is preferably used as the hydrosilylation cross-linking component.

In the formulas, R⁴ represents the same or different phenyl groups or alkyl groups having 1 to 6 carbon atoms. Examples of alkyl groups of R⁴ include methyl groups, ethyl groups, propyl groups, butyl groups, pentyl groups, hexyl groups, cyclopentyl groups, and cyclohexyl groups. Note that of all R⁴s, the amount of phenyl groups is in the range of 30 to 70 mol%.

Furthermore, in the formula, "n" represents an integer in the range of 5 to 1,000. In the formula, "p" represents a positive number, "q" represents 0 or a positive number, "r" represents a positive number, "s" represents 0 or a positive number, and "t" represents 0 or a positive number. Moreover, "q"/"p" is a number in the range of 0 to 10, "r"/"p" is a number in the range of 0.1 to 5, "s"/("p"+"q"+"r"+"s") is a number in the range of 0 to 0.3, and "t"/("p"+"q"+"r"+"s") is a number in the range of 0 to 0.4.

In component (B), it is preferable to use components (B1) and (B2) in combination from the standpoint of easily controlling the curing rate of the composition and the crosslinking density of the resulting cured product. A suitable ratio of the two components is in the range of (B1):(B2) = 0.05 to 0.6 : 0.4 to 0.95 per alkenyl group of the entire composition, preferably in the range of 0.05 to 0.5 : 0.5 to 0.95, and more preferably in the range of 0.05 to 0.4 : 0.5 to 0.95.

While the content of component (B) is not limited, for curing the composition, it is preferable that the amount of silicon atom bonded hydrogen atoms be within the range of 0.5 to 20 mol or within the range of 1.0 to 10 mol with regard to 1 mol of alkenyl group in the composition.

### [Component (C)]

Component (C) is a platinum family metal-based hydrosilylation catalyst for promoting the hydrosilylation reaction between the hydrosilylation reactive carbon-carbon double bond in component (A) and the silicon-bonded hydrogen atoms in component (B). Examples of component (C) include platinum-based catalysts, rhodium-based catalysts, and palladium-based catalysts, but platinum-based catalysts are preferred because platinum-based catalysts are able to significantly accelerate curing of the composition. The platinum-based catalyst is known, and examples thereof include a platinum-alkenylsiloxane complex. The alkenyl siloxane in the complex is not limited, but is preferably 1,3-divinyl-1,1,3,3-tetramethyldisiloxane. In addition, from the view point of improving the handling workability and the pot life of the present composition, component (C) may be a hydrosilylation reaction catalyst that does not exhibit activity without being irradiated with a higher energy beam, but may exhibit activity in the composition by being irradiated with a high energy beam.

That is, component (C) according to the present invention may be at least one catalyst for a hydrosilylation reaction selected from the group consisting of:
(C1) a hydrosilylation catalyst which exhibits activity in the composition when heated;
(C2) a hydrosilation reaction catalyst which exhibits activity in the composition when irradiated with a high energy beam.

The curable silicone composition of the present invention has both the storage stability and the low-temperature rapid curability. When it contains (C1) component, the hydrosilation reaction catalysts are activated by heat as a trigger. When (C2) component is contained, the hydrosilation reaction catalysts are activated by exposure to a high energy beam as a trigger. Once the catalyst is activated, rapid curing can be achieved within a range from room temperature to 60°C.

Component (C1) is typically a platinum-alkenylsiloxane complex. The structure of the alkenylsiloxane is not limited, but 1,3-divinyl-1,1,3,3-tetramethyldisiloxane is exemplary because of the favorable stability of the complex. For example, when the curable silicone composition of the present invention containing component (C1) is heated at a temperature of more than 25°C and 60°C or less, the cure reaction proceeds rapidly even at a low temperature of 60 °C or less. Moreover, in the case where the composition is not heated, component (C1) does not exhibit activity and the composition as a whole does not undergo a hardening reaction, the reaction can be easily controlled.

Similarly, component (C2) is a so-called high energy beam activated catalyst or photo-activated catalyst, which is known in the present technical field. By using component (C), the composition as a whole can be cured even at low temperatures of 60°C or less triggered by irradiation with a high energy beam, has excellent storage stability, and facilitates reaction control, and thus the properties of excellent handling workability can be achieved.

Examples of high energy beams include UV rays, gamma rays, X-rays, alpha rays, electron beams, and the like. In particular, examples include ultraviolet rays, X-rays, and electron beams irradiated from a commercially available electron beam irradiating device. Of these, ultraviolet rays are preferable from the perspective of efficiency of catalyst activation, and ultraviolet rays within a wavelength range of 280 to 410 nm are preferable from the perspective of industrial use. Furthermore, the irradiation dose varies depending on the type of high energy beam activated catalyst, but in the case of ultraviolet light, the integrated irradiation dose at a wavelength of 365 nm is preferably within a range of 100 mJ/cm² to 100 J/cm².

Specific examples of this component (C2) include trimethyl(methylcyclopentadienyl) platinum (IV), (cyclopentadienyl) trimethyl platinum (IV), (1,2,3,4,5-pentamethyl cyclopentadienyl) trimethyl platinum (IV), (cyclopentadienyl) dimethylethyl platinum (IV), (cyclopentadienyl) dimethylacetyl platinum (IV), (trimethylsilyl cyclopentadienyl) trimethyl platinum (IV), (methoxycarbonyl cyclopentadienyl) trimethyl platinum (IV), (dimethylsilyl cyclopentadienyl) trimethylcyclopentadienyl platinum (IV), trimethyl (acetylacetonato) platinum (IV), trimethyl (3,5-heptanedionate) platinum (IV), trimethyl (methylacetoacetate) platinum (IV), bis(2,4-pentanedionato) platinum (II), bis(2,4-hexanedionato) platinum (II), bis(2,4-heptanedionato) platinum (II), bis(3,5-heptanedionato) platinum (II), bis(1 - phenyl-1,3-butanedionato) platinum (II), bis(1,3-diphenyl-1,3-propanedionato) platinum (II), and bis(hexafluoroacetylacetonato) platinum (II). Of these, (methylcyclopentadienyl) trimethyl platinum (IV) and bis(2,4-pentanedionato) platinum (II) are preferred from the perspective of versatility and ease of acquisition.

The amount of component (C) is an amount required to further cure the composition, and is preferably an amount in which metal atoms in the catalyst are within a range of 1 to 500 ppm based on mass units, and preferably within a range of 5 to 200 ppm, with regard to the composition.

### [Component (D)]

Component (D) is one of the characteristic features of the present invention, and is a branched organopolysiloxane having a curing reactive functional group (typically an alkenyl group) containing a carbon-carbon double bond in an amount exceeding 10 mass% at a molecular terminal and containing 10 mol% or more of a branched siloxane unit represented by RSiO_{3/2} (where R is a monovalent organic group, a hydroxyl group, or an alkoxy group) or SiO_{4/2}, and is a component that greatly improves the curing rate of the curable silicone composition of the present invention at low temperatures by adding a certain amount and a small amount.

Specifically, it is considered that since component (D) contains a high concentration of a curing reactive functional group as compared with component (A), the probability of contact with component (B) which is a crosslinking component is higher than that of component (A) described above, and the time until the reaction starts can be shortened. In addition, once the hydrosilylation reaction is initiated, the remaining curing reactive functional groups containing carbon-carbon double bonds in component (A) also begin to react. As a result, it is thought that the curing reaction of the whole composition is accelerated even at low temperatures.

On the other hand, component (D) contains a large amount of reactive functional groups in the molecule at a high density. When a large amount is blended in the composition, the crosslinking density between molecules increases more than necessary, and the obtained cured product tends to become brittle. Therefore, in order to provide a cured product having a mechanical strength practical as an adhesive, a sealing agent, a member for a semiconductor device, or a member for an optical semiconductor device, the content of component D needs to be in a range of 0.1 to 5 mass%, preferably in a range of 0.5 to 4.5 mass%, and particularly preferably in a range of 0.5 to 3.0 mass%, with respect to the total amount of components (A) to (D).

Component (D) may be an organosiloxane compound having any structure as long as the above conditions are satisfied. An example is organopolysiloxane satisfying c' + d' ≥ 0.1 and containing, in a molecule, 10 mass% or more of alkenyl groups as shown in the following formula:

(R¹₃SiO_{1/2})_{a'}(R²₂SiO_{2/2})_{b'}(R²SiO_{3/2})_{c'}(SiO_{4/2})_{d'}(R³O_{1/2})_{e'}

(wherein, each R¹ is independently a monovalent hydrocarbon group having 1 to 10 carbon atoms, provided at least 2 of all R¹ in a molecule are alkenyl groups, while each R² is independently a monovalent hydrocarbon group having 1 to 10 carbon atoms not containing an alkenyl group; and each R³ is a hydrogen atom or an alkyl group having 1 to 10 carbon atoms).

In the formula, each of R¹, R², R³ are the same groups mentioned above, with examples including the same groups mentioned above. a', b', c', d' and e'are numbers which satisfy the following 0.40 ≤ a' ≤ 0.80, 0 ≤ b' ≤ 0.90, 0 ≤ c' ≤ 0.60, 0 ≤ d' ≤ 0.50, and 0 ≤ e' ≤ 0.05, wherein a' + b' + c' + d' = 1 and c' + d' ≥ 0.1.

From the standpoint of increasing the curing rate of the present composition, at least three of R¹ in component (D) should be alkenyl groups and the molecule should contain more than 10 mass%, preferably 12 to 40 mass%, of alkenyl groups in R¹. On the other hand, if an alkenyl group is present in R², the curing rate of the composition tends to be slow, and therefore, it is preferred that an alkenyl group is present only in R¹. When the content of alkenyl groups in component (D) is within the above range, the curing rate of the curable silicone composition of the present invention can be effectively increased without deteriorating the mechanical strength of the cured product of the composition. Exemplary alkenyl groups in component (D) may include a vinyl group, an allyl group, a butenyl group, a pentenyl group, and a hexenyl group.

In the formula, a' is a number indicating the proportion of siloxane units represented by the general formula R¹₃SiO_{1/2}, satisfying 0.40 ≤ a' ≤ 0.90, and preferably 0.50 ≤ a' ≤ 0.85. This is because when a' is below the upper limit of the above range, the strength of the resulting cured material is good, while when a' is above the lower limit of the range, the curing rate of the composition is suitably improved. In the formula, b' is a number indicating the proportion of siloxane units represented by the general formula: R²₂SiO_{2/2}, satisfying 0 ≤ b' ≤ 0.50. This is because when b' is below the upper limit of the above range, the effect of improving the strength of the resulting cured material is sufficient. In addition, c' is a number indicating the proportion of siloxane units represented by the general formula R²SiO_{3/2}, and satisfying 0 ≤ c' ≤ 0.60. This is because the mechanical strength of the cured product is better when c' is below the upper limit of the above range. Moreover, d' is a number indicating the proportion of siloxane units represented by the general formula SiO_{4/2}, and satisfying 0 ≤ d≤ 0.50. This is because the mechanical strength of the resulting cured product is good when d' is below the upper limit of the above range. In addition, e' is a number indicating the proportion of units represented by the general formula: R²O_{1/2} and satisfying 0 ≤ e' ≤ 0.05. This is because the hardness of the resulting cured product at room temperature is better when e' is below the upper limit of the above range. Note that, in the formula, the sum of a', b', c', and d' is 1, and the sum of c' and d' is 0.1 or more.

Because of the structure described above, component (D) is liquid at room temperature, making it particularly suitable if its viscosity at 25°C is 10,000 Pa·s or less.

### [Component (E)]

As described above, unlike components (A) and (B), component (E) is a non-curable organopolysiloxane but can also impart hot-melt properties to the composition as a whole by being used in combination with component (A1) that is an organopolysiloxane resin component and is solid at 25°C, and component (A2) that is liquid or fluid, in the above-described predetermined amount ranges. Furthermore, by using component (E) in combination with components (A1) and (A2) described above within predetermined amount ranges, excellent stress relaxing properties can be suitably imparted to the cured product obtained by curing the curable silicone composition according to the present invention.

Specifically, component (E) is a branched organopolysiloxane resin without a curing reactive functional group containing a carbon-carbon double bond in a molecule, and contains 20 mol% or more of a branched siloxane unit as represented by SiO_{4/2}. Component (E) alone does not have hot-melt properties, and is a solid organopolysiloxane resin in a solvent-free state at 25°C.

Component (E) does not contain a curing reactive functional group containing a carbon-carbon double bond such as an alkenyl group or the like in a molecule, while preferably containing a monovalent hydrocarbon group with 1 to 10 carbon atoms without a carbon-carbon double bond, and particularly preferably a functional group selected from methyl groups and other alkyl groups with 1 to 10 carbon atoms, and aryl groups. On the other hand, component (E) preferably has a percentage of phenyl groups and other aryl groups in all silicon-bonded organic groups within a range of 0 to 5 mol%, more preferably within a range of 0 to 2 mol%, and most preferably does not contain aryl groups at all (= 0 mol%). If the amount of aryl groups in component (E) exceeds the aforementioned upper limit (if a large amount of phenyl groups or other aryl groups are included), component (E) itself may have hot-melt properties, the technical effect of the present invention may not be achieved, and in the cured product, an effect of reinforcing the cured product inherent to SiO_{4/2} groups may be reduced, and deterioration of coloring resistance of the cured product may occur under high temperatures.

Preferably, 70 to 100 mol% of the silicon atom-bonded organic groups in component (E) are preferably methyl groups, 80 to 100 mol% are more preferably methyl groups, and 88 to 100 mol% are particularly preferably methyl groups. Within this range, component (E) can be a component that does not individually exhibit hot-melt properties, and that is particularly effective in reinforcing a cured material containing siloxane units represented by SiO_{4/2}. Note that the organopolysiloxane resin of component (E) may contain a small amount of hydroxyl groups or alkoxy groups.

Component (E) is an organopolysiloxane resin that is solid at 25°C in a solvent-free state, and contains a siloxane unit represented by SiO_{4/2} making up at least 20 mol% or more of all siloxane units, which is a branched siloxane unit, in a molecule. Preferably, the SiO_{4/2} unit of the organopolysiloxane of component (E) is at least 40 mol%, more preferably 50 mol% or more, and particularly preferably within a range of 50 to 65 mol% of all siloxane units.

Suitably, component (E) is an organopolysiloxane resin (E1) as represented by the following average unit formula:

(R³₃SiO_{1/2})_{f}(R³₂SiO_{2/2})_{g}(R³SiO_{3/2})ₕ(SiO_{4/2})ᵢ(R²O_{1/2})ⱼ

(where each R³ independently represents a monovalent hydrocarbon group with 1 to 10 carbon atoms and that does not contain a carbon-carbon double bond; R² represents a hydrogen atom or an alkyl group with 1 to 10 carbon atoms; and f, g, h, i, and j represent numbers that satisfy 0.35 ≤ f ≤ 0.55, 0 ≤ g ≤ 0.20, 0 ≤ h ≤ 0.20, 0.45 ≤ i ≤ 0.65, 0 ≤ j ≤ 0.05, and f + g + h + i = 1).

In the average unit formula above, R² represents the same group as above, and is preferably a hydrogen atom or a methyl group. R³ independently represents a monovalent hydrocarbon group having 1 to 10 carbon atoms and containing no carbon-carbon double bond, such as a methyl or other alkyl group. Herein, it is particularly preferred from the perspective of industrial production and the technical effect of the invention that 70 mol% or more, and more preferably 88 mol% or more of the total R³ in one molecule is a methyl group or other alkyl group with 1 to 10 carbon atoms, and particularly a methyl group. On the other hand, R³ is preferably substantially free of phenyl groups and other aryl groups.

In the formula above, "f" represents a number indicating the percentage of siloxane units in the general formula: R³₃SiO_{1/2}. 0.35 ≤ f ≤ 0.55, preferably 0.40 ≤ f ≤ 0.50 is satisfied. If "f" is within the range above, the curable silicone composition containing this component can be provided with favorable hot-melt properties, and a cured product thereof will have excellent adhesive properties and mechanical strength (hardness and the like).

In the formula above, "g" represents a number indicating the percentage of siloxane units in the general formula: R¹₂SiO_{2/2}. "g" is a value that satisfies 0 ≤ g ≤ 0.20, and preferably satisfies 0 ≤ g ≤ 0.10. If "g" is at or below the upper limit of the range, the curable silicone composition containing this component will have favorable hot-melt properties and the composition will be less sticky at room temperature. In the present invention, "g" may be 0 and is preferably 0.

In the formula, "h" is a number indicating the percentage of siloxane units in the general formula: R¹SiO_{3/2}. "h" is a value that satisfies 0 ≤ h ≤ 0.20, and preferably satisfies 0 ≤ h ≤ 0.10. If "h" is at or below the upper limit of the range, the curable silicone composition containing this component will have favorable hot-melt properties and the composition will be less sticky and the surface will have low tack at room temperature. In the present invention, "h" may be 0 and is preferably 0.

In the formula above, "i" represents a number indicating the percentage of SiO_{4/2} siloxane units, and preferably satisfies 0.30 ≤ i ≤ 0.65, and particularly preferably satisfies 0.50 ≤ i ≤ 0.65. When "i" is within the numerical value range, the curable silicone composition containing this component can achieve favorable hot-melt performance as a whole composition, and thus a composition can be achieved, which has excellent mechanical strength of a cured product obtained by curing the curable silicone composition, has no stickiness as a whole composition, and has favorable handling workability.

In the formula above, "j" is a number indicating the percentage of units of the general formula: R²O_{1/2}, where the units are a hydroxyl group or alkoxy group bonded to a silicon atom that can be included in the organopolysiloxane resin. "j" is a value that satisfies 0 ≤ j ≤ 0.05, and preferably satisfies 0 ≤ j ≤ 0.03. Note that in the formula above, the sum of "f", "g", "h", and "i", which is the sum of each siloxane unit, is equal to 1.

Component (E) is solid at room temperature and is preferably used in a form dissolved in a solvent or solvent mixture for physical mixing with the above-described component (A1) and component (A2). Herein, the type of solvent is the same as that of component (A1).

### [Component (R) = component (A1) and component (E)]

When the curable silicone composition according to the present invention as a whole has a hot-melt properties, it contains, as an organopolysiloxane resin component (component (R)) that is solid at 25°C, the aforementioned components (A1) and (E) at a mass ratio of 20:80 to 90:10, preferably 35:65 to 90:10, more preferably 50:50 to 90:10. Herein, although each component of components (A1) and (E) does not itself have hot-melt properties, hot-melt properties of the whole composition can be achieved by concomitantly using component (A2) described above in a predetermined mass ratio range. By using component (A1) in combination with component (E) in the present composition, it is possible to adjust to a certain degree the storage elastic modulus, loss elastic modulus, and tanδ calculated from the ratio therefrom of a cured product obtained by curing the curable composition, thereby achieving an elastic modulus, flexibility, and stress relaxation properties that are suitable for the cured product.

Components (A1) and (E) preferably have a mass loss ratio of 2.0 mass% or less when exposed to 200°C for 1 hour. These components are organopolysiloxane resins containing M units (R³₃SiO_{1/2}) and Q units (SiO_{4/2}), and volatile low molecular weight components, specifically M₄Q structures, are generated as by-products during the polymerization process. However, this structure has significantly reduced strength of a cured product obtained from the curable silicone composition of the present invention, and if a curable silicone composition containing the M₄Q structure is molded together with a substrate of a semiconductor or the like, and then exposed to a high temperature to remove the M₄Q structure, the volume of a cured product resulting from the curable silicone composition may decrease and the hardness of the cured product may significantly increase, resulting in changes in the dimensions of a molded product, warping, and the like. Furthermore, there is a possibility that the tackiness of the surface of the cured product may increase. Furthermore, if a large amount of M₄Q structure remains in the composition or cured product, a marked increase in hardness may also occur in the adhesive layer or sealing layer for double-sided adhesion, and the elastic modulus may change significantly. Therefore, in order to apply the curable silicone compositions of the present invention to applications laminated with a substrate of a semiconductor or the like, the M₄Q structure is preferably removed from the organopolysiloxane resin at the point of a raw material prior to a molding process of curing with the curable silicone composition by laminating with a substrate, and, if possible, prior to preparing the curable silicone composition.

However, the M₄Q structure is highly compatible with organopolysiloxane resins, and it is difficult to remove volatile low molecular weight components, specifically the M₄Q structure, from components (A1) and (E) and the like under drying conditions that remove organic solvents. Therefore, volatile components can be removed by treating the obtained crude raw material, organopolysiloxane resin, for a short time at a high temperature of approximately 200°C. Hence, volatile components such as organic solvents and M₄Q structures and the like can be simultaneously removed from components (A1) and (E) using a twin-screw kneader or the like set at a temperature of 200°C or higher. Thereby, volatile low molecular weight components in components (A1) and (E) are removed from the raw material before the curable silicone composition is prepared, and thus these components preferably have a mass loss ratio of 2.0 mass% or less after 1 hour of exposure at 200°C, but the mass loss ratio is more preferably 1. 0 mass% or less.

Note that from the perspective of efficient production of the curable hot-melt silicone composition of the present invention, component (A2) described above is preferably added to components (A1) and (E) that are dissolved in an organic solvent, and the mixture is fed in a liquid state into a twin-screw extruder set at 200°C or higher, and a process of removing volatile components such as M₄Q structures and the like is performed. This method enables obtaining a mixture of components (A1), (E) and (A2) having hot-melt properties, which can be used for kneading in the remaining components included in the curable silicone composition in a process described later.

### [Hydrosilylation Reaction Curing Retarder]

In addition to components (A) to (D) above, the curable silicone composition of the present invention may further contain a hydrosilylation reaction curing retarder. The structure of the curing retarder is not particularly limited, but when melting and kneading raw materials are performed under reduced pressure in the production process of the curable silicone composition, use of (E) a hydrosilylation reaction curing retarder with a boiling point of 200°C or higher under atmospheric pressure is particularly preferred. This is because, if a compound with a low boiling point is used as a curing retarder, a portion or all of the curing retarder may volatilize during the melting and kneading process, and thus a targeted effect of the curing retarding effect may not be achieved with the curable silicone composition.

The cure retarding agent of the present invention is not particularly limited, and examples include: 2-methyl-3-butyne-2-ol, 3,5-dimethyl-1-hexyne-3-ol, 2-phenyl-3-butyne-2-ol, 1-ethynyl-1-cyclohexanol, and other alkyne alcohols; 3-methyl-3-pentene-1-yne, 3,5-dimethyl-3-hexene-1-yne, and other enyne compounds; tetramethyltetravinylcyclotetrasiloxane, tetramethyltetrahexenylcyclotetrasiloxane, and other alkenyl group-containing low molecular weight siloxanes; and methyl tris(1,1-dimethyl propynyloxy)silane, vinyl tris(1,1-dimethyl propynyloxy)silane, and other alkynyloxysilanes. Of these, the use of (E) a curing retarder with a boiling point of 200°C or higher under atmospheric pressure is particularly preferred, and for practical use, the use of alkynyloxysilanes such as methyl-tris(1,1-dimethylpropynyloxy)silane and vinyl-tris(1,1 dimethylpropynyloxy)silane, and the like is preferred. The amount of the curing retarder in the curable silicone composition is not particularly limited, but is preferably within a range of 1 to 10,000 ppm in mass units, with regard to the composition.

### [(F) Other Additives]

In addition to the above components (A) to (D) and optional component (E), materials known in the art as additives that may be used in a silicone composition may be added to the curable silicone composition of the present invention. Herein, the additives that can be used include, but are not limited to, the following. Note that when melting and kneading raw materials under reduced pressure in the production process of the curable silicone composition and based on the technical effects of the present invention, it is particularly preferable that the other additives have a high boiling point or be a component that is substantially non-volatile.

### [(F1) Functional Filler]

A functional filler can be used as an additive in order to improve the mechanical properties of a cured product obtained from the curable silicone composition of the present invention, to improve flame retardancy, or the like. Examples of these functional fillers include inorganic fillers, organic fillers, and mixtures thereof. Examples of the inorganic fillers include reinforcing fillers, pigments (particularly white pigments and black pigments), thermally conductive fillers, electrically conductive fillers, phosphors, and mixtures of at least two of these, and examples of organic fillers include a silicone resin filler, a fluorine resin filler, and a polybutadiene resin filler. Note that the shape of these fillers is not particularly limited and may be spherical, spindle-shaped, flat, needle-shaped, amorphous, or the like.

The type and amount of functional filler are preferably selected to be within a range in which the curable silicone composition of the present invention can be melted and kneaded and within a range that enables the technical effects of the present invention (such as curing properties, mechanical properties after curing, weather resistance, and the like).

Moreover, if component (C2) is cured by triggering irradiation of a high energy beam to drive the curing reaction, the high energy beam may be shielded, absorbed, or reflected on the surface of the composition if functional fillers that are light-shielding or light-absorbing/reflecting, such as white or black pigments, are included at a large amount. Therefore, the curability of the composition may deteriorate significantly.

On the other hand, if the curable silicone composition contains light-shielding or light-absorbing/reflecting functional fillers (for example, black pigments, white pigments, and the like) as component (F1), then the hydrosilylation reaction catalyst, component (C1) mentioned above, is preferably used. This is because when such a filler is included, transparency or light transmissivity is basically not required, and the composition containing these pigments can be quickly cured by heating as a trigger.

### [(F2) Adhesion Imparting Agent]

The composition of the present invention may contain an adhesion imparting agent so long as the object of the present invention is not impaired. Such adhesion imparting agents are common to components suitably exemplified by the present applicant in the WO 2020/203304 A1, and reaction mixtures of epoxy group-containing organoalkoxysilane and amino group-containing organoalkoxysilane disclosed in JP 52-8854 B2 and JP 10-195085 A, and particularly carbasilatrane derivatives having a silicon atom-bonded alkoxy group or silicon atom-bonded alkenyl group in one molecule, silatrane derivatives having an alkoxysilyl group-containing organic group, and the like can be preferably used in addition to 3-glycidoxypropyltrimethoxysilane and other silane compounds, organosiloxane oligomers, and alkyl silicates. The amount of the adhesion imparting agent is not limited, but is preferably within a range of 0.01 to 10 parts by mass relative to 100 parts by mass total of the present composition.

### [Other optional components]

Furthermore, the composition may contain, as other optional components, heat resistance agents such as iron oxide (red iron oxide), cerium oxide, cerium dimethyl silanolate, fatty acid cerium salt, cerium hydroxide, zirconium compound, and the like; and in addition, dyes, pigments other than white, flame retardancy imparting agents, and the like.

### [Shape Retention and Melt Viscosity of Composition]

The curable silicone composition according to the present invention can impart hot-melt properties to the whole composition by its composition design, and in particular, a hot-melt composition can be obtained which is a solid having shape retention at 25°C, but has a melt viscosity at 100°C (measured by a flow tester: outlet nozzle size 1 mm, pressure 2.5 MPa) of 50 Pa·s or less. Note that shape retention means that the material does not substantially deform or flow in the absence of an external force, and may be a solid or raw rubber-like solid that can be deformed or plasticized by applying an external force. Furthermore, when the melt viscosity at 100°C is 50 Pa·s or less, more preferably 30 Pa·s or less, the dispensing property at the temperature is improved.

### [Manufacturing Method and Form of Filling Cartridge, Pail or Drum]

The curable silicone composition of the present invention can be manufactured by heating and melting, and then uniformly mixing components (A) to (D), along with (E) and other optional components, and then cooling if necessary. However, the composition may be manufactured by any method, not limited to this method. The mixer that can be used with this manufacturing method is not particularly limited, and examples can include batch type mixers with heating and cooling functions, such as kneaders, Banbury mixers, Henschel mixers, planetary mixers, two-roller mills, three-roller mills, Ross mixers, Labo Plastomills, and the like; and continuous type heating and kneading devices with heating and cooling functions, such as single-screw extruders, twin-screw extruders, and the like. The curable silicone composition according to the present invention is particularly suitable for use in a form of being filled in cartridges, pails, or drums, heated, and dispensed using a dispenser; therefore, it is particularly preferable to manufacture the composition using a single-shaft or twin-shaft continuous mixer, from the perspective of being able to continuously fill the containers.

The curable silicone composition according to the present invention is particularly preferably used in a form filled in cartridges, pails, or drums filled for dispensing. It is preferable that these cartridges, pails, or drums containing the curable silicone composition are obtained by continuously filling the containers with curable silicone compositions.

### [Dispensing Cartridge and Use Thereof]

The curable silicone composition according to the present invention can be filled into dispensing cartridges and can be suitably used for hot dispensing. Heat-resistant cartridges for dispensing can be used and are preferably used. The dispensing cartridge filled with a curable silicone composition can be used by a dispenser equipped with a heating part (for example, a temperature control unit) that is commonly distributed. In particular, the curable silicone composition of the present invention may have hot-melt properties. Therefore, if the cartridge is heated to 50°C or higher, suitably 50 to 150°C, and preferably 80 to 120°C by a temperature control unit, the composition can be smoothly dispensed at a dispensing pressure of approximately 0.5 MPa, for example, and thus can be used for hot dispensing. On the other hand, in the case of pails and drums, for example, a Nordson hot melter can be used to extrude the composition under high temperature and dispense the composition through a heat resistant hose.

### [Other Forms of Compositions and Variations of Manufacturing Methods]

The curable silicone composition according to the present invention is suitably in the form of being filled into a dispensing cartridge, pail, or drum, but may also be in the form of a molded product such as a tablet, pellet, sheet, or film, as required. The molded product, particularly a sheet or film made of the curable silicone composition can be used in a form where at least one surface of an uncured curable silicone composition sheet or film is adhered to a portion or all of a substrate serving as an electronic component or a precursor thereof, by one or more means selected from a vacuum laminator, vacuum press, and compression molding, and then irradiating with a high energy beam in order to cure the composition.

### [One-Component Composition]

The curable silicone composition according to the present invention may be liquid and is highly stable during storage at room temperature. When, however, component (C1) is included, the hydrosilation reaction catalysts are activated by heating as a trigger, and when component (C2) is included, the hydrosilation reaction catalysts are activated by exposure to high energy beam as a trigger. Onece the catalyst is activated, rapid curing can be achieved within the range of room temperature to 60°C. Note that, even in the case of a one-component composition, the composition may be in a form filled in a dispensing cartridge, pail, or drum, and may be used in a form to be applied to a desired place by hot dispensing depending on the viscosity or plasticity thereof.

### [Curing of Curable Silicone Composition and Manufacture of Laminate Body]

As described above, the curable silicone composition of the present invention undergoes a rapid curing reaction even at low temperatures particularly when triggered by heating or irradiation with a high energy beam. For example, while the composition is being dispensed from a dispenser or the like, or immediately after the composition is applied to a substrate, the composition is heated or irradiated with a high energy beam, and a curing reaction at a low temperature proceeds.

More specifically, the curable silicone composition of the present invention has an advantage of achieving rapid curability by adopting a low-temperature curing process where the composition is cured through a process of activating one or more catalysts for a hydrosilylation reaction selected from the following processes, within a temperature in the range of 25°C to 60°C: process A: a process of activating a hydrosilylation reaction catalyst by heating the composition at a temperature of higher than 25°C and 60°C or lower; and process B: a process of activating a hydrosilylation reaction catalyst by irradiating the composition with a high energy beam.

In particular, when the composition is liquid or has hot-melt properties, this can be suitably used when the composition is to be cured in an as-dispensed form, and is specifically applicable to sealing and encapsulating substrates. A rapid curing reaction at a low temperature can be achieved immediately after the composition is dispensed and adhesion to the substrate occurs. Moreover, if necessary, the obtained laminate body can be further post-cured by exposure to a temperature of 10°C or higher than the curing temperature to form a fully cured product.

On the other hand, after dispensing the composition of the present invention onto the substrate with a dispenser, the composition may be irradiated with a high energy beam after a period of time. Even in this case, when the composition of the present invention has hot-melt properties, the composition has shape retention at room temperature (25°C); therefore, the dispensed material does not change shape due to dripping or the like. Furthermore, the shape of the composition can be changed to form an adhesive layer that joins two substrates together by adhering (preferably by pressing, for example, by applying an external force) a second substrate to the substrate on which the dispensed composition is placed. If neither of the two substrates is a light-impermeable material, it is necessary to irradiate with a high energy beam before pressure bonding the substrate to the second substrate. On the other hand, if one of the two substrates is a light transmitting substrate such as glass, the two substrates can be laminated together before irradiating with the high energy beam.

By these methods of use, in the case of producing a laminate having a structure in which a part or all of the surfaces of at least two substrates are bonded via a cured product formed of the composition of the present invention, the manufacturing method having the following processes is particularly preferable:
process (I): process of heating a curable silicone composition according to the present invention by a dispenser equipped with a heating part if necessary to make the composition fluid, and dispensing the composition onto a portion or all of the surface of at least one substrate;
process (II): process of, simultaneously with or after process (I), heating or irradiating the curable silicone composition dispensed from the dispenser with a high energy beam at a low temperature directly or through another substrate; and if necessary,
process (III): process of, after process (I), and before or after process (II), adhering the curable silicone composition dispensed from the dispenser to another substrate.

Herein, in process (I), precision coating is also possible by connecting a heatable slot die to the outlet of the dispenser to dispense the product in a film or sheet form with a desired thickness, and applying the product as is in the form of the substrate. Note that the curing reaction of the curable silicone composition according to the present invention proceeds over time at room temperature or at low temperature with heating, to form the cured product, and therefore may be left at room temperature (around 25°C) or exposed to a low temperature of 60°C or lower to cure the composition.

The substrate used with the above methods of use and in the laminate body is a member for electronic components, semiconductor devices or optical semiconductor devices, and the substrate with cured product containing the curable silicone composition according to the present invention (including laminate bodies having a structure in which at least two of the above substrate surfaces are bonded via the cured products) is an electronic component, semiconductor device, or optical semiconductor device, or is useful as a member thereof.

In the curable silicone composition of the present invention, if (C2) a photoactive hydrosilylation reaction catalyst is used as component (C), the catalyst can be activated by irradiation with a high energy beam such as ultraviolet light or the like, and thus the hydrosilylation reaction in the composition proceeds, forming a cured product. The types of high energy beams are as described above. The irradiation dose depends on the type of the high energy beam activated catalyst, but in the case of UV rays, the integrated irradiation dose at 365 nm is preferably within a range of 100 mJ/cm² to 100 J/cm², may be within a range of 500 mJ/cm² to 50 J/cm², and may be within a range of 500 mJ/cm² to 20 J/cm². In other words, the curing reactive silicone composition of the present invention can initiate a curing reaction triggered by irradiation with a high energy beam such as UV rays or the like. Furthermore, the curing reaction rate can be controlled to some extent by changing the integrated irradiation dose. Note that once the hydrosilylation catalyst, which is component (C2), is activated, the curing reaction proceeds over time at room temperature or by heating to form a cured product even after irradiation with a high energy beam is stopped.

The curing reaction can be performed at a low temperature region (60°C or lower), including room temperature (25°C). Note that in the embodiments of the present invention, "low temperature" refers to a temperature range of, for example, 60°C or lower, specifically, 25°C to 60°C. The present composition may suitably be left at or near room temperature range (a temperature range that can be reached without heating or cooling, particularly including a temperature range of 20 to 25°C). Note that the time required for the curing reaction can be designed as appropriate based on the irradiation dose of a high-energy beam of UV rays or the like and the temperature. Furthermore, heating above 60°C may be temporarily performed if tolerable and necessary for the process.

On the other hand, when the curable silicone composition of the present invention contains (C1) heat curable hydrosilation catalysts as component (C), the procedure is as described above, except that the catalysts are activated by exposure to a temperature range between room temperature (25°C) to 60°C, and the hydrosilation reaction proceeds.

The curable silicone composition of the present invention may be in a form of a liquid composition, or may be a hot-melt composition that exhibits fluidity by heating and can be applied to transfer molding or compression molding used for molding of a liquid composition, using a heating unit as necessary. These molding processes dispense the liquid composition directly into the molding machine, which is an unsuitable process for applying compositions that cannot be cured without irradiation with a high energy beam, but the curable silicone composition containing component (C1) has an advantage that the curing reaction proceeds at a low temperature and for a short time, and thus is suitable for use in these molding processes.

### [Hardness of Cured Product and Compatible Use Form]

A preferred hardness of the cured product obtained by curing the curable silicone composition of the present invention can be classified into two categories depending on an application thereof. When adherends are adhered to both surfaces of the curable silicone composition of the present invention (in other words, with use as an adhesive), the Type A durometer hardness specified in "Durometer Hardness Test Method for Plastics" of JIS K 7215-1986 is preferably 30 or higher. This is because if the hardness is at or below the lower limit described above, the cured product tends to be too soft and brittle. On the other hand, if the application thereof is substrate sealing or encapsulation (in other words a sealing-agent-like use), the Type A durometer hardness is preferably 40 or higher. This is because if the hardness is at or below the lower limit described above, the surface of the cured product becomes sticky, and thus handling performance is reduced.

### [Applications of Composition/Cured Product]

The curable silicone compositions described above can be used as a sealant or sealing agent by dispensing the cured product to a substrate surface, and curing by the method described above, because the cured products have relatively low tack and have a low surface stickiness. Furthermore, it is also possible to use the composition as a bonding layer or adhesive layer between different substrates (members) by adhering another substrate (suitably, by applying external force to press the substrate against the composition layer to deform the composition layer and cause adhesion) before the dispensed composition cools, and then curing the composition by the method described above.

In other words, the curable silicone composition according to the present invention is suitable as an adhesive or a sealing agent with curing properties that are triggered by high energy beam irradiation or heating at a low temperature. In particular, uncured or semi-cured composition layers made of the curable silicone composition according to the present invention and cured products made by curing the composition are useful as members of electronic components, semiconductor devices or optical semiconductor devices.

Specifically, the curable silicone composition according to the present invention has excellent storage stability, excellent handling workability and curability, and excellent coloring resistance of the resulting cured product obtained by curing the present composition at high temperature. Therefore, the composition is useful for sealing materials for semiconductor members such as light emitting and optical devices, optical reflective materials and the like, as well as optical semiconductors containing the cured product. Furthermore, the cured product has excellent mechanical properties and is relatively hard with low tackiness. Therefore, the cured product is suitable as: a sealing agent for semiconductors; a sealing agent for power semiconductors such as SiC, GaN, or the like; or as an adhesive, potting agent, protective agent, coating agent, or sealant for electrical and electronic applications. The composition is particularly suitable for use as a sealant that is required to retain shape after dispensing, or as a sealing agent for semiconductors that requires a thick layer. This composition (uncured or semi-cured composition layer) is adhered to a substrate and suitably crushed by an external force between two substrates to form a film that can be used as an adhesive layer or a stress buffer layer between two substrates with different coefficients of linear expansion. Note that the curable silicone composition of the present invention may be a sealing agent for single-sided sealing or for double-sided sealing along with adhesion between two substrates, and has preferred properties suitable for these applications.

Note that the curable silicone composition of the present invention can be flexibly adapted to desired applications and curing processes by selecting and optimizing component (C) and its form (component having hot-melt properties or being liquid at room temperature), and thus can be applied to electronic components, semiconductor devices or optical semiconductor device members or precursors thereof to meet a wide range of functional and process requirements.

The cured product obtained by curing the curable silicone composition of the present invention has no particular limitations on applications, but can be suitably used as a component for electronic components, semiconductor devices, and optical semiconductor devices, and can be suitably used as a sealing material for semiconductor elements and IC chips and the like, or as an adhesive, bonding member, or sealant for semiconductor devices, and is particularly suitable for applications requiring high heat resistance and light resistance.

The semiconductor device provided with a member containing the cured product obtained by curing the curable silicone composition of the present invention is not particularly limited, but is preferably a light emitting semiconductor device, which is a light emitting/optical device, an optical member for displays, a member for solar panels, and in particular, is used as a sealing material, casing material, or adhesive member for these devices or the like. Furthermore, the cured product of the present invention has excellent coloring resistance at high temperatures, and therefore is more preferably used as a sealing material, case material, or adhesive member used in electronic materials where transparency and light/heat resistance are important.

As described above, the curable silicone composition of the present invention may be in the form of a tablet, pellet, sheet or film molded product, and may be used by curing or molding, arranged as components for electronic components, semiconductor devices or optical semiconductor device members in forms other than hot dispensing.

### EXAMPLES

The curable silicone composition of the present invention and manufacturing method thereof are described below in detail using examples and comparative examples. Note that in the following description, Me, Vi, and Ph in the average unit formula represent methyl, vinyl, and phenyl groups, respectively. Furthermore, the melt viscosity, softening point, curability, and storage stability of the curable silicone compositions of each Example and Comparative Example were measured by the following methods. The results are shown in Table 1.

### [Melt Viscosity at 100°C]

The melt viscosity of the curable silicone composition at 100°C was measured using a Koka-type flow tester CFT-500EX (manufactured by Shimadzu Corporation) using a nozzle with a 1.0 mm outlet nozzle diameter at 2.5 MPa pressure.

### [Hot Dispensing Properties (Initial)]

A cartridge filled with the curable silicone composition was placed in a temperature control unit (THERMO MASTER TCU-02 manufactured by Musashi Engineering) attached to a desktop coating robot (SHOT mini 200Sx manufactured by Musashi Engineering), and the temperature setting of the temperature control unit was set to 100°C to warm the cartridge. After the cartridge was sufficiently warmed, a test was conducted to determine whether the composition could be smoothly dispensed by dispensing on a glass plate using a digital dispenser (ML-606GX manufactured by Musashi Engineering Co., Ltd.) at a pressure of 0.5 MPa.

### [Hot Dispensing Properties (After 5 Hours at 100°C)/Stability of Composition During Dispensing]

A cartridge filled with the curable silicone composition was placed in a temperature control unit (THERMO MASTER TCU-02 manufactured by Musashi Engineering) attached to a desktop coating robot (SHOT mini 200Sx manufactured by Musashi Engineering), and the temperature setting of the temperature control unit was set to 100°C, and maintained for 5 hours. Next, a test was conducted to determine whether the composition could be smoothly dispensed by dispensing on a glass plate using a digital dispenser (ML-606GX manufactured by Musashi Engineering Co., Ltd.) at a pressure of 0.5 MPa.

### [Curing properties]

The curable silicone composition was vulcanized for 600 seconds at a predetermined temperature using a curastometer (PREMIERMDR manufactured by Alpha Technologies) in accordance with a method specified in JIS K 6300-2:2001, "Unvulcanized Rubber - Physical Properties - Part 2: Determination of Vulcanization Characteristics Using a Vibratory Vulcanization Tester" to measure the curing properties.
- The measurements for Examples 1 to 3 and Comparative Examples 1 to 2 were performed at 60°C.
- In examples 4 to 8 and comparative Examples 3 to 7, ultraviolet light with a wavelength of 365 nm was irradiated at a dose of 10 J/cm², and the measurements were performed at 60°C.

Note that the measurement was performed by weighing approximately 5 g of the curable silicone composition, interposing between 50 µm-thick PET films, placing on a lower die, and closing the upper die before initiating measurement. Note that the measurements were made using an R-type die for rubber, with an amplitude angle of 0.53°, a vibration frequency of 100 times/minute, and a maximum torque range of 230 kgf-cm. As a result of the measurement, the time (TS-1) required to exceed a torque value of 1 dNm was read in units of minutes.

### [Room Temperature (25°C) Curing Properties]

After the curable silicone compositions (examples 4 to 8 and comparative examples 3 to 7) were prepared, they were irradiated with ultraviolet light having wavelengths in the 365 nm region at an irradiation dose of 10 J/cm², then allowed to stand at a temperature of 25°C, and after 24 hours, the curability was confirmed by touching with a hand. The case where the surface was not sticky was evaluated as OK, and the case where the surface was sticky even after 24 hours was evaluated as NG.

### [Tensile Elongation of Cured Product]

The curable silicone composition was heated at 150°C for two hours to prepare a cured product. The tensile elongation rate of the cured product was measured using the method specified in JIS K 6251-2010 "Vulcanized Rubber and Thermoplastic Rubber - Determination of Tensile Properties."

The following compounds were used in the Examples and Comparative Example described below.
- Component (a1):
   Organopolysiloxane resin (amount of vinyl groups = 1.9 mass%) which is a white solid at 25°C and represented by the average unit formula:

   (Me₂ViSiO_{1/2})_{0.05}(Me₃SiO_{1/2})_{0.39}(SiO_{4/2})_{0.56}(HO_{1/2})_{0.02}
- Component (a2-1): Dimethylpolysiloxane capped at both molecular terminals with dimethylvinylsiloxy groups (amount of vinyl groups = 0.13 mass%) and represented by the formula:

   ViMe₂SiO(Me₂SiO)₅₀₀SiViMe₂
- Component (a2-2): Dimethylpolysiloxane capped at both molecular terminals with dimethylvinylsiloxy groups (amount of vinyl groups = 0.09 mass%) and represented by the formula:

   ViMe₂SiO(Me₂SiO)₈₀₀SiViMe₂
- Component (b1):
   Organohydrogenpolysiloxane represented by the formula:

   (PhSiO_{3/2})_{0.4}(HMe₂SiO_{1/2})_{0.6}
- Component (b2):
   Organohydrogenpolysiloxane represented by the formula: (HMe₂SiO)₂SiPh₂
- Component (b3): Organohydrogenpolysiloxane represented by the formula:

   HMe₂SiO(Me₂SiO)₁₇SiMe₂H
- Component (c1):
   1,3-divinyltetramethyldisiloxane solution of 1,3-divinyl-1,1,3,3-tetramethyldisiloxane complex of platinum
- Component (c2):
   (Methylcyclopentadienyl) trimethyl platinum (IV) complex
- Component (d1):
   Branched organopolysiloxane containing vinyl groups at the molecular ends with a viscosity of 5 mPa·s (vinyl group content = 23 mass%), represented by the following formula:

   (ViMe₂SiO_{1/2})_{0.75}(PhSiO_{3/2})_{0.25}
- Component (d2):
   Branched organopolysiloxane containing vinyl groups at the molecular ends with a viscosity of 3 mPa·s (vinyl group content = 27 mass%), represented by the following formula:

   (ViMe₂SiO_{1/2})_{0.80}(SiO_{4/2})_{0.20}
- Component (d3):
   Branched organopolysiloxane containing vinyl groups at the molecular ends with a viscosity of 300 mPa·s (vinyl group content = 19 mass%), represented by the following formula:

   (Me₂ViSiO_{1/2})_{0.55}(Me₃SiO_{1/2})_{0.05}(SiO_{4/2})_{0.40}
- Component (d4):
   Linear organopolysiloxane containing vinyl groups at the molecular ends with a viscosity of 8 mPa·s (vinyl group content = 16 mass%), represented by the following formula:

   (ViMe₂SiO)₂SiPh₂
- Component (d5):
   Cyclic methyl vinyl polysiloxane with a viscosity of 4 mPa·s (vinyl group content = 30 mass%), represented by the following formula:

   (MeViSiO)₄
- Component (e):
   Organopolysiloxane resin (amount of vinyl groups = 0 mass%) which is a white solid at 25°C and represented by the average unit formula:

   (Me₃SiO_{1/2})_{0.44}(SiO_{4/2})_{0.56}(HO_{1/2})_{0.02}
- Component (f1): 1-ethynyl-1-cyclohexanol
- Component (f2): Methyltris-1,1-dimethyl-2-propynyloxysilane

### [Examples 1 to 3 and Comparative Examples 1 to 2: One-component curable silicone composition, heat curing]

One-component curable silicone compositions having flowability were prepared by mixing each component in the parts listed in Table 1. The viscosity at a shear rate of 10 (1/s) at 25°C, curability at 60°C, and tensile elongation rate of the cured product thereof are shown in the table.

**[Table 1]**

| | EXAMPLE 1 | EXAMPLE 2 | EXAMPLE 3 | COMPARATIVE EXAMPLE 1 | COMPARATIVE EXAMPLE 2 |
|---|---|---|---|---|---|
| a1 | 41.55 | 41.59 | 40.56 | 42.53 | 36.30 |
| a2-1 | 50.79 | 50.83 | 49.57 | 51.99 | 44.40 |
| b1 | 6.92 | 6.09 | 8.24 | 5.48 | 13.90 |
| b2 | | 0.74 | | | |
| c1 | 5 | 5 | 5 | 5 | 5 |
| d1 | 0.92 | 0.92 | 1.80 | 0 | 6.00 |
| f1 | 200 | 200 | 200 | 200 | 200 |
| Viscosity [Pa·s] | 42 | 36 | 23 | 55 | 9 |
| ts-1 @ 60°C [min] | 13 | 9 | 7 | 22 | 5 |
| Tensile elongation rate (%) | 210 | 220 | 200 | 220 | 90 |

### [Summary]

Examples 1 to 3 containing a small amount of component (D) were cured by the hydrosilation reaction catalyst that is active when heated, which is component (C1), but compared to Comparative Example 1 that does not contain component (D), the results of measuring TS-1 showed rapid curability at 60°C. On the other hand, it was found that the cured product obtained in Comparative Example 2 containing 5 mass% or more of component (D) was significantly inferior in tensile elongation rate to the cured products in Examples 1 to 3. From the above results, it was found that the addition of component (D) within a predetermined range could improve the curing rate at low temperature without deteriorating the mechanical strength.

### [Preparation of Mixtures 1 to 4 and Amount of Volatile Component (Reference Examples 1 to 4)]

In each Reference Example, components (a1), (a2-2), and (e) in the amounts (kg) shown in Table 2 below were dissolved in 4.00 kg of xylene in a pail can using a three-one motor. The obtained solution was fed into a twin-screw extruder with the maximum attainable temperature set at 230°C The xylene and low molecular weight organopolysiloxane components were removed under a degree or vacuum of -0.08 MPa, resulting in transparent hot-melt mixtures 1 to 4. The mixtures 1 to 4 were placed in a cylindrical pail can and cooled to a solid state. The results of measuring the amount of volatile components of each mixture at 200°C for 1 hour are shown in Table 2 as "Amount of volatile components (mass%)".

**[Table 2]**

| Reference Example No./Component (kg) | 1 | 2 | 3 | 4 |
|---|---|---|---|---|
| (a1) | 2.10 | 2.26 | 2.35 | 2.40 |
| (a2-2) | 3.52 | 3.05 | 3.99 | 2.69 |
| (e) | 3.92 | 4.21 | 3.17 | 4.46 |
| Amount of volatile components (mass%) | 0.7 | 0.7 | 0.7 | 0.7 |

### [Examples 4 to 8 and Comparative Examples 3 to 7: Hot Melt Silicone Composition, Photoactive Pt Catalyst Used]

In the following Examples and Comparative Examples, the above mixtures 1 to 4 and components described above were used. A twin-screw extruder of the form depicted in FIG. 1 was used in preparing the compositions for each example. Furthermore, the properties of each of the obtained curable silicone compositions are shown in Table 3.

### [Example 4]

Mixture 1 was fed into a twin-screw extruder ("2a" in FIG. 1) at 170°C using a hot melter (VersaPail Melter manufactured by Nordson "1" in FIG. 1) for cylindrical pails at 9.54 kg/hr.

Next, a mixture containing component (b1) at a rate of 0.37 kg/hr, component (b3) at a rate of 0.2 kg/hr, component (d1) at a rate of 0.1 kg/hr and component (f2) at 300 ppm with regard to the total of the composition was fed using pump 3-a depicted in FIG. 1. The set temperature of the feeding part was 150°C. Next, a mixture containing component (a2-2) at a rate of 0.15 kg/hr and component (c2) (an amount that provides 10 ppm by mass of platinum metal based on the entire composition) was fed by the pump 3-b depicted in FIG. 1 (the set temperature of the feeding part was 80°C), where the degree of vacuum in the extruder was -0.08 MPa, to perform degassing melt-kneading.

The outlet temperature of the twin-screw extruder was 80°C, and the mixture was in the form of a semi-solid softened material at that temperature. A nozzle with a diameter of 2.5 cm and a length of 13 cm was attached to the outlet of the twin-screw extruder (2b), and the obtained mixture was continuously filled into a heat-resistant cartridge (Unity HiTemp syringe, manufactured by Nordson) with a capacity of 30 mL.

### [Example 5]

Mixture 2 was fed into a twin-screw extruder ("2a" in FIG. 1) at 170°C using a hot melter (VersaPail Melter manufactured by Nordson "1" in FIG. 1) for cylindrical pails at 9.52 kg/hr.

Next, a mixture containing component (b1) at a rate of 0.42 kg/hr, component (b3) at a rate of 0.22 kg/hr, component (d2) at a rate of 0.1 kg/hr and component (f2) at 300 ppm with regard to the total of the composition was fed using pump 3-a depicted in FIG. 1. The set temperature of the feeding part was 150°C.

Next, a mixture containing component (a2-2) 0.15 kg/hr and component (c2) (an amount that provides 10 ppm by mass of platinum metal based on the entire composition) was fed by the pump 3-b depicted in FIG. 1 (the set temperature of the feeding part was 80°C), where the degree of vacuum in the extruder was -0.08 MPa, to perform degassing melt-kneading.

The outlet temperature of the twin-screw extruder was 80°C, and the mixture was in the form of a semi-solid softened material at that temperature. A nozzle with a diameter of 2.5 cm and a length of 13 cm was attached to the outlet of the twin-screw extruder (2b), and the obtained mixture was continuously filled into a heat-resistant cartridge (Unity HiTemp syringe, manufactured by Nordson) with a capacity of 30 mL.

### [Example 6]

Mixture 3 was fed into a twin-screw extruder ("2a" in FIG. 1) at 170°C using a hot melter (VersaPail Melter manufactured by Nordson "1" in FIG. 1) for cylindrical pails at 9.51 kg/hr.

Next, a mixture containing component (b1) at a rate of 0.38 kg/hr, component (b3) at a rate of 0.2 kg/hr, component (d3) at a rate of 0.1 kg/hr and component (f2) at 300 ppm with regard to the total of the composition was fed using pump 3-a depicted in FIG. 1. The set temperature of the feeding part was 150°C.

Next, a mixture containing component (a2-2) at a rate of 0.15 kg/hr and component (c2) (an amount that provides 10 ppm by mass of platinum metal based on the entire composition) was fed by the pump 3-b depicted in FIG. 1 (the set temperature of the feeding part was 80°C), where the degree of vacuum in the extruder was -0.08 MPa, to perform degassing melt-kneading.

The outlet temperature of the twin-screw extruder was 80°C, and the mixture was in the form of a semi-solid softened material at that temperature. A nozzle with a diameter of 2.5 cm and a length of 13 cm was attached to the outlet of the twin-screw extruder (2b), and the obtained mixture was continuously filled into a heat-resistant cartridge (Unity HiTemp syringe, manufactured by Nordson) with a capacity of 30 mL.

### [Example 7]

Mixture 1 was fed into a twin-screw extruder ("2a" in FIG. 1) at 170°C using a hot melter (VersaPail Melter manufactured by Nordson "1" in FIG. 1) for cylindrical pails at 9.54 kg/hr.

Next, a mixture containing component (b1) at a rate of 0.41 kg/hr, component (d1) at a rate of 0.1 kg/hr and component (f2) at 300 ppm with regard to the total of the composition was fed using pump 3-a depicted in FIG. 1. The set temperature of the feeding part was 150°C.

Next, a mixture containing component (a2-2) at a rate of 0.15 kg/hr and component (c2) (an amount that provides 10 ppm by mass of platinum metal based on the entire composition) was fed by the pump 3-b depicted in FIG. 1 (the set temperature of the feeding part was 80°C), where the degree of vacuum in the extruder was -0.08 MPa, to perform degassing melt-kneading.

The outlet temperature of the twin-screw extruder was 80°C, and the mixture was in the form of a semi-solid softened material at that temperature. A nozzle with a diameter of 2.5 cm and a length of 13 cm was attached to the outlet of the twin-screw extruder (2b), and the obtained mixture was continuously filled into a heat-resistant cartridge (Unity HiTemp syringe, manufactured by Nordson) with a capacity of 30 mL.

### [Example 8]

Mixture 2 was fed into a twin-screw extruder ("2a" in FIG. 1) at 170°C using a hot melter (VersaPail Melter manufactured by Nordson "1" in FIG. 1) for cylindrical pails at 9.52 kg/hr.

Next, a mixture containing component (b1) at a rate of 0.45 kg/hr, component (d2) at a rate of 0.1 kg/hr and component (f2) at 300 ppm with regard to the total of the composition was fed using pump 3-a depicted in FIG. 1. The set temperature of the feeding part was 150°C.

Next, a mixture containing component (a2-2) at a rate of 0.15 kg/hr and component (c2) (an amount that provides 10 ppm by mass of platinum metal based on the entire composition) was fed by the pump 3-b depicted in FIG. 1 (the set temperature of the feeding part was 80°C), where the degree of vacuum in the extruder was -0.08 MPa, to perform degassing melt-kneading.

The outlet temperature of the twin-screw extruder was 80°C, and the mixture was in the form of a semi-solid softened material at that temperature. A nozzle with a diameter of 2.5 cm and a length of 13 cm was attached to the outlet of the twin-screw extruder (2b), and the obtained mixture was continuously filled into a heat-resistant cartridge (Unity HiTemp syringe, manufactured by Nordson) with a capacity of 30 mL.

### [Comparative Example 3]

Mixture 1 was fed into a twin-screw extruder ("2a" in FIG. 1) at 170°C using a hot melter (VersaPail Melter manufactured by Nordson "1" in FIG. 1) for cylindrical pails at 9.54 kg/hr.

Next, a mixture containing component (b1) at a rate of 0.31 kg/hr and component (f2) at 300 ppm with regard to the total of the composition was fed using pump 3-a depicted in FIG. 1. The set temperature of the feeding part was 150°C.

Next, a mixture containing component (a2-2) at a rate of 0.15 kg/hr and component (c2) (an amount that provides 10 ppm by mass of platinum metal based on the entire composition) was fed by the pump 3-b depicted in FIG. 1 (the set temperature of the feeding part was 80°C), where the degree of vacuum in the extruder was -0.08 MPa, to perform degassing melt-kneading. The outlet temperature of the twin-screw extruder was 80°C, and the mixture was in the form of a semi-solid softened material at that temperature. A nozzle with a diameter of 2.5 cm and a length of 13 cm was attached to the outlet of the twin-screw extruder (2b), and the obtained mixture was continuously filled into a heat-resistant cartridge (Unity HiTemp syringe, manufactured by Nordson) with a capacity of 30 mL.

### Comparative Example 4

Mixture 2 was fed into a twin-screw extruder ("2a" in FIG. 1) at 170°C using a hot melter (VersaPail Melter manufactured by Nordson "1" in FIG. 1) for cylindrical pails at 9.52 kg/hr.

Next, a mixture containing component (b1) at a rate of 0.33 kg/hr and component (f2) at 300 ppm with regard to the total of the composition was fed using pump 3-a depicted in FIG. 1. The set temperature of the feeding part was 150°C.

Next, a mixture containing component (a2-2) at a rate of 0.15 kg/hr and component (c2) (an amount that provides 10 ppm by mass of platinum metal based on the entire composition) was fed by the pump 3-b depicted in FIG. 1 (the set temperature of the feeding part was 80°C), where the degree of vacuum in the extruder was -0.08 MPa, to perform degassing melt-kneading.

The outlet temperature of the twin-screw extruder was 80°C, and the mixture was in the form of a semi-solid softened material at that temperature. A nozzle with a diameter of 2.5 cm and a length of 13 cm was attached to the outlet of the twin-screw extruder (2b), and the obtained mixture was continuously filled into a heat-resistant cartridge (Unity HiTemp syringe, manufactured by Nordson) with a capacity of 30 mL.

### Comparative Example 5

Mixture 1 was fed into a twin-screw extruder ("2a" in FIG. 1) at 170°C using a hot melter (VersaPail Melter manufactured by Nordson "1" in FIG. 1) for cylindrical pails at 9.54 kg/hr.

Next, a mixture containing component (b1) at a rate of 0.28 kg/hr, component (b3) at a rate of 0.13 kg/hr, component (d1) at a rate of 0.005 kg/hr and component (f2) at 300 ppm with regard to the total of the composition was fed using pump 3-a depicted in FIG. 1. The set temperature of the feeding part was 150°C.

Next, a mixture containing component (a2-2) at a rate of 0.15 kg/hr and component (c2) (an amount that provides 10 ppm by mass of platinum metal based on the entire composition) was fed by the pump 3-b depicted in FIG. 1 (the set temperature of the feeding part was 80°C), where the degree of vacuum in the extruder was -0.08 MPa, to perform degassing melt-kneading.

The outlet temperature of the twin-screw extruder was 80°C, and the mixture was in the form of a semi-solid softened material at that temperature. A nozzle with a diameter of 2.5 cm and a length of 13 cm was attached to the outlet of the twin-screw extruder (2b), and the obtained mixture was continuously filled into a heat-resistant cartridge (Unity HiTemp syringe, manufactured by Nordson) with a capacity of 30 mL.

### Comparative Example 6

Mixture 2 was fed into a twin-screw extruder ("2a" in FIG. 1) at 170°C using a hot melter (VersaPail Melter manufactured by Nordson "1" in FIG. 1) for cylindrical pails at 9.52 kg/hr.

Next, a mixture containing component (b1) at a rate of 0.38 kg/hr, component (b3) at a rate of 0.20 kg/hr, component (d4) at a rate of 0.10 kg/hr and component (f2) at 300 ppm with regard to the total of the composition was fed using pump 3-a depicted in FIG. 1. The set temperature of the feeding part was 150°C.

Next, a mixture containing component (a2-2) at a rate of 0.15 kg/hr and component (c2) (an amount that provides 10 ppm by mass of platinum metal based on the entire composition) was fed by the pump 3-b depicted in FIG. 1 (the set temperature of the feeding part was 80°C), where the degree of vacuum in the extruder was -0.08 MPa, to perform degassing melt-kneading.

The outlet temperature of the twin-screw extruder was 80°C, and the mixture was in the form of a semi-solid softened material at that temperature. A nozzle with a diameter of 2.5 cm and a length of 13 cm was attached to the outlet of the twin-screw extruder (2b), and the obtained mixture was continuously filled into a heat-resistant cartridge (Unity HiTemp syringe, manufactured by Nordson) with a capacity of 30 mL.

### Comparative Example 7

Mixture 3 was fed into a twin-screw extruder ("2a" in FIG. 1) at 170°C using a hot melter (VersaPail Melter manufactured by Nordson "1" in FIG. 1) for cylindrical pails at 9.51 kg/hr.

Next, a mixture containing component (b1) at a rate of 0.50 kg/hr, component (b3) at a rate of 0.23 kg/hr, component (d5) at a rate of 0.10 kg/hr and component (f2) at 300 ppm with regard to the total of the composition was fed using pump 3-a depicted in FIG. 1. The set temperature of the feeding part was 150°C.

Next, a mixture containing component (a2-2) at a rate of 0.15 kg/hr and component (c2) (an amount that provides 10 ppm by mass of platinum metal based on the entire composition) was fed by the pump 3-b depicted in FIG. 1 (the set temperature of the feeding part was 80°C), where the degree of vacuum in the extruder was -0.08 MPa, to perform degassing melt-kneading.

The outlet temperature of the twin-screw extruder was 80°C, and the mixture was in the form of a semi-solid softened material at that temperature. A nozzle with a diameter of 2.5 cm and a length of 13 cm was attached to the outlet of the twin-screw extruder (2b), and the obtained mixture was continuously filled into a heat-resistant cartridge (Unity HiTemp syringe, manufactured by Nordson) with a capacity of 30 mL.

**[Table 3]**

| | | EXAMPLE 4 | EXAMPLE 5 | EXAMPLE 6 | EXAMPLE 7 | EXAMPLE 8 |
|---|---|---|---|---|---|---|
| Melt viscosity @ 100°C [Pa·s] | | 8 | 17 | 5 | 10 | 18 |
| Hot dispensing properties | INITIAL | Good | Good | Good | Good | Good |
| | 100°C, after 5 hours | Good | Good | Good | Good | Good |
| TS-1 @ 60°C [min] | | 24 | 15 | 37 | 38 | 24 |
| Curability after 24 hours at 25°C | | Cured | Cured | Cured | Cured | Cured |

| | | COMPARATIVE EXAMPLE 3 | COMPARATIVE EXAMPLE 4 | COMPARATIVE EXAMPLE 5 | COMPARATIVE EXAMPLE 6 | COMPARATIVE EXAMPLE 7 |
|---|---|---|---|---|---|---|
| Melt viscosity @ 100°C [Pa·s] | | 10 | 20 | 9 | 15 | 3 |
| Hot dispensing properties | INITIAL | Good | Good | Good | Good | Good |
| | 100°C, after 5 hours | Good | Good | Good | Good | Good |
| TS-1 @ 60°C [min] | | > 50 | > 50 | > 50 | > 50 | > 50 |
| Curability after 24 hours at 25°C | | Uncured | Uncured | Uncured | Uncured | Uncured |

### [Summary]

Examples 3 to 8, which are hot-melt curable silicone compositions containing a predetermined amount of component (D) having a specific structure and further containing component (C2) having a specific structure, were found to be highly stable at 100°C before UV radiation, while the reaction proceeded rapidly even at low temperature (60°C) when the catalyst was activated by UV radiation, as shown in the results of measuring TS-1. On the other hand, it was found that Comparative Examples 3 and 4, which did not contain component (D), had excellent stability at 100°C before UV irradiation, but were hardly cured at a low temperature even after UV irradiation. In addition, it was found that in a case where the addition amount of component (D) is too small (Comparative Example 5) or in a case where the component (D) having a structure outside the scope of the present invention is contained (Comparative Examples 6 and 7), the composition is hardly cured at a low temperature even after UV irradiation, and thus it was found that it is important for the present invention to add a predetermined amount of component (D) having a specific structure.

### [Example 9]

Mixture 4 was fed into a twin-screw extruder at 170°C by a hot-melter (VersaPail Melter manufactured by Nordson) for cylindrical pails at 9.55 kg/hr from a hot-melter 1 as illustrated in FIG. 2.

Next, a mixture containing component (b1) at a rate of 0.45 kg/hr, component (d1) at a rate of 0.1 kg/hr and component (f2) at 300 ppm with regard to the total of the composition was fed using line 3-a depicted in FIG. 2. The set temperature of the feeding part was 150°C.

Next, a mixture containing component (a2-2) at 0.15 kg/hr and component (c2) (an amount that provides 10.0 ppm by mass of platinum metal based on the entire composition) was fed by the line 3-b depicted in FIG. 1 (the set temperature of the feeding part was 80°C), where the degree of vacuum in the extruder was -0.08 MPa, to perform degassing melt-kneading.

The outlet temperature of the twin-screw extruder was set at 80°C. The mixture was in the form of semi-solid softened material. While transporting 330 mm wide and 125-µm-thick release films (FL2-01 manufactured by TAKARA INC. CO. Ltd.) at a rate of 1.0 m/min, the mixture was supplied onto a release film such that the feed rate was 5 kg/hr. The mixture was then interposed between two release films such that a release surface of the release film was in contact with the mixture to form a laminate body (the same applies in the following Examples). Subsequently, the laminate body was then pressed between rollers with temperatures controlled at 90°C to stretch the mixture between the release films to form a laminate body in which a curable hot-melt silicone composition sheet having a thickness of 300 µm was interposed between the two release films. The entire laminate body was then cooled by air cooling. The configuration of the manufacturing device is illustrated in Fig. 2. When the release film was released from the obtained laminate body, a flat, homogeneous, tack-free, transparent curable hot-melt silicone composition sheet without bubbles was obtained, and the softening temperature thereof was 80°C. The obtained curable hot-melt silicone composition sheet was irradiated with ultraviolet light with a 365 nm wavelength at an irradiation dose of 10 J/cm², and then the curability at 100°C was measured by the method described above. The ts-1 thereof was 38 seconds. The curable hot-melt silicone composition sheet was aged in an oven at 40°C for one week, then irradiated with ultraviolet light as described above. The curability at 100°C was again measured, and the ts-1 thereof was 41 seconds.

The obtained curable hot-melt silicone composition sheet was irradiated with ultraviolet light as described above and allowed to stand at 25°C for 24 hours, whereupon the film surface was no longer sticky and curing was complete.

### DESCRIPTION OF CODES

1: Hot melter
2-a: Extruder
2-b: Dispensing port (may optionally be fitted with a nozzle for cartridge filling)
3-a: Pump
3-b: Pump
3-c: Vacuum pump
4-a: Release sheet
4-b: Release sheet
5-a: Stretching roller (optionally further equipped with a temperature control function)
5-b: Stretching roller (optionally further equipped with a temperature control function)
6: Cooling roller
7: Film thickness meter
8: Sheet cutter
9: Foreign material inspecting machine

## Claims

1. A curable silicone composition containing: (A) an organopolysiloxane having a curing reactive functional group containing a carbon-carbon double bond at a molecular terminal and having a content thereof in a range of 0.001 to 10 mass%;
(B) an organohydrogenpolysiloxane having at least 2 silicon-bonded hydrogen atoms in each molecule at a molecular terminal;
(C) a hydrosilylation reaction catalyst;
(D) a branched organopolysiloxane having a curing reactive functional group containing a carbon-carbon double bond in an amount exceeding 10 mass% in a molecule at a molecular terminal and containing 10 mol% or more of a branched siloxane unit represented by RSiO_{3/2} (wherein R is a monovalent organic group, a hydroxyl group or an alkoxy group) or SiO_{4/2};
wherein the content of component (D) is in the range of 0.1 to 5 mass% relative to the total amount of components (A) to (D).

2. The curable silicone composition according to claim 1, wherein at least a portion of component (A) is (A1) a branched organopolysiloxane having a curing reactive functional group containing a carbon-carbon double bond at a molecular terminal and containing 20 mol% or more of a branched siloxane unit represented by RSiO_{3/2} (where R is a monovalent organic group, a hydroxyl group or an alkoxy group) or SiO_{4/2}.

3. The curable silicone composition according to claim 1 or claim 2, wherein at least a portion of component (A) is (A2-1) a linear organopolysiloxane having a curing reactive functional group containing a carbon-carbon double bond at a molecular terminal.

4. The curable silicone composition according to any one of claims 1 to 3, wherein component (B) contains a combination of two types of compounds:
(B-1) a linear organopolysiloxane represented by the general formula:
HR⁴₂SiO(R⁴₂SiO)ₙSiR⁴₂H,
and
(B-2) a branched organopolysiloxane expressed by the average unit formula:
(R⁴SiO_{3/2})ₚ(R⁴₂SiO_{2/2})_{q}(HR⁴₂SiO_{1/2})ᵣ(SiO_{4/2})ₛ(XO_{1/2})ₜ.
(wherein R⁴ are the same or different phenyl groups or alkyl groups having 1 to 6 carbon atoms, provided that the phenyl group content is within the range of 30 to 70 mol% for all R⁴,
n is an integer within the range of 1 to 50, p is a positive number, q is 0 or a positive number, r is a positive number, s is 0 or a positive number, t is 0 or a positive number, q/p is a number within the range of 0 to 10, r/p is a number within the range of 0.1 to 5, s/(p + q + r + s) is a number within the range of 0 to 0.3, and t/(p + q + r + s) is a number within the range of 0 to 0.4.)
and the amounts of component (B-1) and component (B-2) are in a range of (B-1): (B-2) = 0.05 to 0.6:0.4 to 0.95 per one curing reactive functional group containing a carbon-carbon double bond in the entire composition.

5. The curable silicone composition according to any one of claims 1 to 4, wherein the component (C) is at least one type of a catalyst for a hydrosilation reaction selected from the group consisting of:
(C1) a hydrosilylation catalyst which exhibits activity in the composition when heated;
(C2) a hydrosilation reaction catalyst which exhibits activity in the composition when irradiated with a high energy beam.

6. The curable silicone composition according to any one of claims 1 to 5, having hot melt properties as the composition as a whole.

7. The curable silicone composition according to claim 1, comprising: (R) 100 parts by mass of an organopolysiloxane resin component that is solid at 25°C, containing the following component (A1) and component (E) at a mass ratio of 20:80 to 90:10:
(A1) a branched organopolysiloxane having a curing reactive functional group containing a carbon-carbon double bond at a molecular terminal and containing 20 mol% or more of a branched siloxane unit represented by RSiO_{3/2} (wherein R is a monovalent organic group, a hydroxyl group, or an alkoxy group) or SiO_{4/2}, and
(E) a branched organopolysiloxane that does not have a curing reactive functional group containing a carbon-carbon double bond in a molecule, and that contains 20 mol% or more of a branched siloxane unit as represented by SiO_{4/2};
(A2-1) 10 to 100 parts by mass of a linear organopolysiloxane having a curing reactive functional group containing a carbon-carbon double bond at both ends of the molecular chain;
(B) a component wherein a combination of two types of organopolysiloxane serves as the component (B), namely,
(B-1) a linear organopolysiloxane represented by the general formula:
HR⁴₂SiO(R⁴₂SiO)ₙSiR⁴₂H,
and
(B-2) a branched organopolysiloxane expressed by the average unit formula:
(R⁴SiO_{3/2})ₚ(R⁴₂SiO_{2/2})_{q}(HR⁴₂SiO_{1/2})ᵣ(SiO_{4/2})ₛ(XO_{1/2})_{t.}.
(wherein R⁴ are the same or different phenyl groups or alkyl groups having 1 to 6 carbon atoms, provided that the phenyl group content is within the range of 30 to 70 mol% for all R⁴,
n is an integer within the range of 1 to 50, p is a positive number, q is 0 or a positive number, r is a positive number, s is 0 or a positive number, t is 0 or a positive number, q/p is a number within the range of 0 to 10, r/p is a number within the range of 0.1 to 5, s/(p + q + r + s) is a number within the range of 0 to 0.3, and t/(p + q + r + s) is a number within the range of 0 to 0.4.)
and the amounts of component (B-1) and component (B-2) are in a range of (B-1): (B-2) = 0.05 to 0.6:0.4 to 0.95 per one curing reactive functional group containing a carbon-carbon double bond in the entire composition;
(C) a component wherein the component (C) is at least one kind of hydrosilation catalyst (catalyst amount) selected from the following:
(C1) a hydrosilylation catalyst which exhibits activity in the composition when heated, and
(C2) a hydrosilation reaction catalyst which exhibits activity in the composition when irradiated with a high energy beam;
and
(D) a branched organopolysiloxane having a curing reactive functional group containing a carbon-carbon double bond in an amount exceeding 10 mass% in a molecule at a molecular terminal and containing 10 mol% or more of a branched siloxane unit represented by RSiO_{3/2} (wherein R is a monovalent organic group, a hydroxyl group or an alkoxy group), or SiO_{4/2},
wherein the content of component (D) is in the range of 0.1 to 5 mass% relative to the total amount of components (A) to (D), and wherein the component has a hot-melt properties as a whole.

8. The curable silicone composition according to any one of claims 1 to 7, wherein component (C) consists essentially of a catalyst (C2) for a hydrosilation reaction that exhibits activity in the composition upon irradiation with a high energy beam.

9. The curable silicone composition according to any one of claims 1 to 8, wherein the component is liquid and in a form of a one-component composition.

10. The curable silicone composition according to any one of claims 1 to 8, having hot melt properties as the composition as a whole, wherein the composition is molded into a sheet or film shape to have a thickness of 10 to 2,000 µm.

11. A cured product obtained by curing a curable silicone composition according to any one of claims 1 to 10.

12. A one-component adhesive or one-component sealing agent, comprising the curable silicone composition according to claim 9.

13. A cartridge comprising a curable silicone composition according to any one of claims 1 to 10, in the form of a dispensing cartridge, pail, or drum filled with the curable silicone composition.

14. A hot-melt adhesive or hot-melt sealing agent, comprising the curable silicone composition molded into a sheet or film shape according to claim 10.

15. Use of a cured product according to claim 11 as a member for a semiconductor device or a member for an optical semiconductor device.

16. A semiconductor device or optical semiconductor device, comprising a cured product according to claim 11.

17. A low-temperature curing method of a curable silicone composition according to any one of claims 1 to 10, wherein the composition is cured through a process of activating one or more catalysts for a hydrosilylation reaction selected from the following processes, within a temperature in the range of 25°C to 60°C:
process A: a process of activating a hydrosilylation reaction catalyst by heating the composition at a temperature of higher than 25°C and 60°C or lower; and
process B: a process of activating a hydrosilylation reaction catalyst by irradiating the composition with a high energy beam.
